(19) **Europäisches Patentamt / European Patent Office / Office européen des brevets**

(11) **EP 1 988 760 B1**

(12) **EUROPEAN PATENT SPECIFICATION**

(45) Date of publication and mention
of the grant of the patent:
**09.06.2010 Bulletin 2010/23**

(51) Int Cl.:
*H05K 7/20* (2006.01)   *G05D 23/19* (2006.01)
*G05D 22/02* (2006.01)

(21) Application number: **07710932.0**

(22) Date of filing: **13.02.2007**

(86) International application number:
**PCT/CN2007/000507**

(87) International publication number:
**WO 2007/095846 (30.08.2007 Gazette 2007/35)**

(54) **TEMPERATURE CONTROL DEVICE, MANAGEMENT DEVICE, SYSTEM AND METHOD**

TEMPERATURSTEUERUNGSVORRICHTUNG SOWIE VERWALTUNGSVORRICHTUNG, SYSTEM UND VERFAHREN DAFÜR

DISPOSITIF DE RÉGULATION DE TEMPÉRATURE, DISPOSITIF DE GESTION DE TEMPÉRATURE, ET SYSTÈME ET PROCÉDÉ ASSOCIÉS

(84) Designated Contracting States:
**AT BE BG CH CY CZ DE DK EE ES FI FR GB GR HU IE IS IT LI LT LU LV MC NL PL PT RO SE SI SK TR**

(30) Priority: **24.02.2006   CN 200610033988**
**30.10.2006   CN 200610150197**

(43) Date of publication of application:
**05.11.2008   Bulletin 2008/45**

(73) Proprietor: **Huawei Technologies Co., Ltd.**
**Longgang District, Shenzhen**
**Guangdong 518129 (CN)**

(72) Inventors:
• **SU, Weixing**
**Shenzhen Guangdong 518129 (CN)**

• **HONG, Yuping**
**Shenzhen Guangdong 518129 (CN)**
• **JIN, Youlin**
**Shenzhen Guangdong 518129 (CN)**

(74) Representative: **Kreuz, Georg Maria et al**
**Huawei Technologies**
**Riesstrasse 25**
**80992 München (DE)**

(56) References cited:
| | |
|---|---|
| EP-A- 1 311 147 | WO-A-01/76340 |
| CN-A- 1 652 675 | JP-A- 09 073 321 |
| JP-A- 2000 242 340 | US-A- 5 934 368 |
| US-A1- 2005 225 936 | US-A1- 2005 278 069 |
| US-B1- 6 208 510 | |

EP 1 988 760 B1

**Description**

Technical Field

The present invention relates to a mechanical apparatus, system and method in electronic or communication field, in particular to a temperature and relative humidity control apparatus, process apparatus, system and method for a cabinet.

Background of the Invention

Electric facilities such as communication, electronic or power equipment are increasingly installed outdoors or at locations without weatherproof and temperature regulating equipment. Outdoor environment is commonly defined as environment without any weather protection, i.e. locations without equipment, for weatherproof and temperature regulating, for example, open air environment, simple equipment room, and so on. Compared with changes in indoor environment, changes in outdoor environment are more complicated. If electric facilities such as communication, electronic or power equipment are exposed in complicated outdoor environment, they tend to be weathered by dust, temperature and humidity in outdoor environment, especially for the equipment sensitive to dust, temperature and humidity.

The deposition of a mass of dust in the equipment will affect the service life of the dustproof net and other electronic elements arranged within the equipment and even cause an operating fault of the equipment. Therefore, it is necessary to control the dust amount entering equipment.

Each kind of electric facilities has a normal operating temperature range. In the case of an extremely high or low outside environmental temperature, if no other protection is provided, components of the electric facilities would have unstable operating states , even be damaged, which may cause an unstable operation or a malfunction for the equipment, even result in an accident. Therefore, it is very necessary to control the equipment temperature within the normal operating temperature range thereof.

When the relative humidity of air inside the equipment is too high, the service life of the equipment will be shorten, and further a manipulating and/or operating fault may occur due to the considerable corrosion caused by the high relative humidity, thereby leading to a potential risk. Therefore, it is very necessary to control the relative humidity of air inside the equipment within an allowable range.

The temperature change of outdoor environment may also have an impact on the change of the relative humidity of air inside the equipment. In the case of a high outdoor temperature, the outside environment temperature and humidity will fluctuate, and a temperature difference between the interior temperature and exterior temperature of the equipment is formed. In this condition, if the outdoor environment temperature makes a rapid change, as a result that the air inside the equipment may be condensed to water. The fact that the air inside the equipment is condensed to water will result in that the relative humidity of air inside the equipment is too high, which does not satisfy the equipment operating requirement and produces a potential risk.

Therefore, when electric facilities such as communication, electronic or power equipment operate outdoors, it is necessary to take a protective measure to avoid or reduce the impacts of the outside environment (for example dust, temperature and moisture and the like) on the equipment, so as to ensure a normal operation of the equipment in the outdoor environment.

A usual protective measure is to install the above-mentioned electric facilities in other outdoor facility, i.e. using the other outdoor facility to protect the above-mentioned electric facilities. In general, the other outdoor facility may include an outdoor cabinet or an equipment box or machine box installed outdoors, herein collectively referred to as a cabinet.

The above-mentioned cabinet can prevent most of dusts from entering the equipment placed in the cabinet, thus reduce the impacts of the dust on the equipment.

However, because most of electric energy consumed during the operation of the equipment is converted into heat energy, the heat energy accumulates in cabinet so that the interior temperature of the cabinet continuously increases, which will affect the normal operation of the equipment inside the cabinet in an extreme condition. Therefore, in order to keep the interior temperature of the cabinet within an allowable range for the normal operation of the equipment, it is necessary to apply a temperature control solution for the cabinet so as to remove the heat produced inside the cabinet in time.

Moisture in the environment may also enter the cabinet through both the inlet of the vent and the door gap of the cabinet. When the relative humidity in the cabinet is high, vapor condensation may occur in the cabinet, which may cause corrosion and the like. For example, as the air temperature decreases, the absolute humidity of the saturated air decreases, which means that the water vapor which could be absorbed by the air reduces and the excess water vapor will be condensed out. Consequently, if the relative humidity is high in the cabinet, water vapor may condense on the cold wall of the cabinet at night due to temperature decrease, which results in a hidden trouble such as short circuit and corrosion. In contrast, as air temperature increases, the absolute humidity of the saturated air increases and the relative humidity decreases. Accordingly, water vapor may condense on the cold wall of the cabinet when the air temperature decreases.

Furthermore, as for the communication and electronic equipment, copper is the primary media for transferring signal and the equipment problem caused by corrosion is mainly copper corrosion. 60%RH is the critical relative humidity point of copper corrosion, and the equipment can be effectively prevented from corrosion by controlling the interior relative humidity of the cabinet below 60%RH. The most effective method for reducing the relative humidity is to heat the wet air. In addition, the relative humidity may also be reduced with a refrigeration dehumidification method or a sorption dehumidification method. But compared with the heating dehumidification method, both the refrigeration dehumidification method and the sorption dehumidification are much more complicated and expensive to be implemented. In the related design, it is mainly to adopt a manner providing auxiliary heat by a heater so as to reduce the relative humidity, which consumes a great deal of power energy and increases the operating cost, and which can't be used when alternating current (AC) is cut off.

A commonly used solution for the control of cabinet temperature is to install a temperature control unit in the cabinet, which mainly includes a heat exchanger and an air conditioner. Adopting the heat exchanger and air conditioner may isolate the cabinet from the outside environment, and thus the effect of preventing dust, salt materials and the like in the outside environment from entering the cabinet is the best. However, both the heat exchanger and the air conditioner are bulky and have relatively big noises. In addition, because heat sinks having a large surface area are adopted inside and outside the cabinet to exchange the heat inside the cabinet and the heat outside the cabinet, the air temperature inside the cabinet with the heat exchanger is higher than the air temperature in the outside environment, which reduces the capability of enduring the maximum environment temperature for the board of the equipment inside the cabinet. Moreover, the air conditioner has a low reliability and high power energy consumption and thus has a high operating cost.

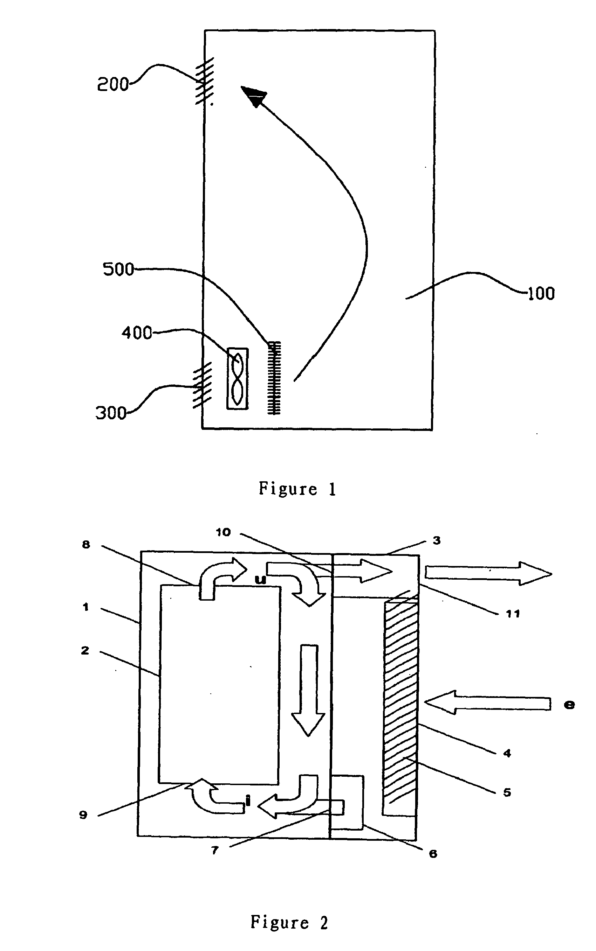

Another commonly used solution for the control of cabinet temperature is to directly introduce the outside environment air into the cabinet to carry out cooling, i.e. the direct-ventilation cooling solution. As shown in Figure 1, in the direct-ventilation cooling solution, vent holes 200 and 300 are defined in the cabinet 100 to dissipate the heat of the board and module of the equipment inside the cabinet 100. Further, a built-in fan 400 is usually fixed in the cabinet to enhance the venting effect. In order to reduce the relative humidity, a heater 500 is fixed in the cabinet to heat the air and thus reduce the relative humidity of air inside the cabinet. When the environment temperature is low, the heater 500 may be used to heat at the low temperature.

Compared with the heat exchanger in above the solution for temperature control, the direct-ventilation cooling solution can eliminate additional temperature gradient between the cabinet interior and the environment, and is advantageous for cooling; and compared with the air conditioner in the above solution of temperature control, the energy consumption of the cooling system is lower in the direct-ventilation cooling solution so that the operating cost can be reduced. Meanwhile, the direct-ventilation cooling solution can reduce noise and can reduce volume of the equipment so that the equipment becomes more compact and the cost for cooling the system is minimized. However, because air is directly introduced from the outdoor environment to cool the electric facilities in the direct-ventilation cooling solution, it is necessary to take measures to isolate water, dust, low temperature and moisture in the outdoor environment from equipment, so as to ensure a reliable operation of the equipment.

In order to control the relative humidity and temperature of air inside the cabinet, the known solution includes: providing a special mixture vent path to solve the problem relating to the relative humidity control and a part of the problem relating to the cooling, and providing dustproof device to solve the problem relating to the dust. In particular, in the cabinet, the heat energy resulted by the equipment operation is used to heat the environmental moisture which is directly absorbed from the outdoor environment, and if the cooling requirement is satisfied, the air in the inlet of the vent is heated so as to vaporize the moisture carried by the air of the air inlet, thereby the relative humidity of the equipment interior can be controlled and the equipment noise can be reduced.

The ventilation volume of the cabinet is controlled according to the relative humidity and temperature valves of the cabinet interior. In other words, a vent path for air circulating is pre-defined in the cabinet, and the ventilation volume of the equipment is controlled according to the detected values of the relative humidity and temperature, respectively, so that the requirements of the cooling and the relative humidity of the cabinet are satisfied by controlling the amount of the air through the inlet and the circulating movement of the air in the predefined circulating vent path.

EP1,311,147A disclosed the related solution, which is particularly shown in Figure 2. The specific structure includes:

a cabinet air inlet 6, from which the air in the outdoor environment enters the cabinet, which is the mixture point of the interior air flow, and from which the air in the outside environment is generally introduced into the cabinet by blasting, whereby cooling of the cabinet may be carried out by the circulating movement of the air in the circulating vent path of the cabinet; and

a cabinet air outlet 10, through which the amount of air may be controlled by a valve so that most of the air inside the cabinet circulating in the cabinet.

In order to reduce the relative humidity, in this technical solution, the amount of the input air and the amount of the output air are controlled by respectively detecting the humidity value and temperature value.

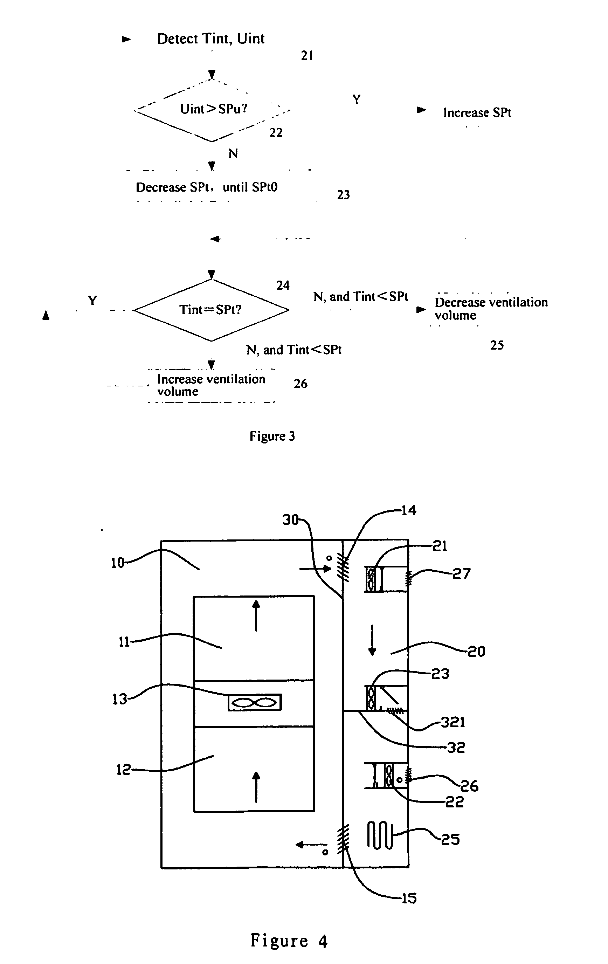

The specific steps of the related control solution are shown in Figure 3. The control target of the cooling control system of the cabinet is to achieve the preset temperature and humidity control table.

The steps of the control solution to control the cabinet temperature and humidity includes:

Step 21: Detect values of a temperature sensor and a humidity sensor to obtain a temperature value $T_{int}$ and a relative humidity value Uint of the cabinet interior, and obtaining a set temperature value SPt and a set relative humidity value SPu by inquiring a temperature and humidity control table according to the detected data;

Step 22: If Uint > SPu, i.e. the relative humidity value of the cabinet interior is higher than the set relative humidity value and thus it is necessary to reduce the relative humidity of the cabinet interior, the relative humidity of the cabinet interior is reduced by rising the set temperature SPt to increase the temperature of the cabinet interior;

Step 23: If Uint≤SPu, i.e. the relative humidity value of the cabinet interior is lower than the set relative humidity value, the relative humidity of the cabinet interior is within the normal range, and thus the set temperature can be adjusted according to the requirement for setting the temperature, then the set temperature value SPt is properly reduced until the SPt reaches the minimum $SP_{t0}$;

Step 24: Adjust the corresponding set temperature value SPt according to the temperature Tint, and thus adjust the ventilation volume of the cabinet;

Step 25: If the temperature value of the cabinet interior equals to the set temperature value, i.e. Tint=SPt, it is determined that the temperature and relative humidity of the cabinet interior has reached the preset target, and thus there is no need to adjust the ventilation volume of the cabinet;

Step 26: If the temperature value of the cabinet interior is lower than the set temperature value, i.e. Tint < SPt, the temperature of the cabinet interior is increased by reducing the ventilation volume of the cabinet such that the temperature of the cabinet interior reach the set value;

Step 27: If the temperature value of the cabinet interior is higher than the set temperature value, i.e. Tint > SPt, the temperature value of the cabinet interior is decrease by increasing the ventilation volume of the cabinet such that the temperature of the cabinet interior reach the set value, thereby solving the cooling problem of the cabinet;

However, the related control solution has the following drawbacks.

Firstly, simply adopting the valve to control the ventilation volume of the equipment cannot precisely control the ventilation volume of the equipment. Therefore, the mixture ratio of the air inside the equipment to the air outside the equipment cannot be controlled. As a result, the stability of the system is poor and the system performance tends to fluctuate during the operating process.

Secondly, in this solution, the temperature is controlled according to the result measured by the temperature sensor, and the relative humidity is controlled according to the result measured by the humidity sensor, and it is necessary to preset the set values corresponding to the complicated relative humidity control and temperature control. Therefore, a very highly professional level is required during the producing and maintaining of the equipment which adopts such solution, and it is relatively expensive for the manufacture, installation, and maintenance of the equipment.

Thirdly, it is known that the humidity sensor is a fragile element, and, in practice, there is a relatively great difference between the actual relative humidity value and the relative humidity value obtained by the humidity sensor. Accordingly, it tends to increase time and money to ensure the maintenance of humidity sensor.

Fourthly, in this solution, it is necessary to acquire and control two parameters, i.e. the relative humidity and temperature, the complexity of the system is increased and thus the reliability of the system is reduced.

Fifthly, the mixture vent path involved in this solution is arranged in the equipment, and the direct-ventilation control module therein is not universal or general, thus, in practice, it is necessary to provide special ventilation equipment for the various equipment to meet the requirement. Therefore, this solution does not meet the requirements of modularization and generalization required in the practical application.

As for the impacts of the water, dust, low temperature in outdoor environment on the equipment arranged inside the cabinet, in the solution, a labyrinth structure is arranged at the vent of the cabinet so as to prevent water from contacting the equipment arranged inside the cabinet.

The solution described above has the following drawback. Because the dust enters the cabinet along with the air flow and deposits on the equipment, a fault such as corrosion and short circuit tends to occur. In the design, air is filtered by a dustproof net placed at the air inlet to reduce the dust, and the dustproof net is cleaned periodically to prevent from clogging. However, the more heat consumption of the equipment is, the more ventilation volume required for cooling is, and the higher the possibility of clogging the dustproof net is, thus there is a need to clean and maintain the dustproof net more frequently, which is time-consuming and laborious.

Because the equipment operating temperature is generally above minus 5-0°C, when the cabinet operates in a low temperature environment below 0°C, the air entering the equipment needs to be heated to 0°C or higher so as to ensure the stable operation of the equipment. In the design, a manner providing auxiliary heat by a heater is adopted, which consumes a great deal of power energy and increases the operating cost.

Besides, US 5,934,368 disclosed an apparatus free from condensation in the cabinet of the apparatus, which comprises a PCB on which heat emitting semiconductor devices are mounted, blowers, a hygrometer, a surface temperature sensor, an internal temperature sensor and a controller. A cooler is provided in the cabinet. Part of the cooling air exhausted by the blowers is fed back into the cabinet through a passage provided with a damper. The controller controls the damper to open or close it.

To sum up the above description, the prior cabinet temperature control solution mainly has following drawbacks.

1. The more heat the equipment consumes, the more ventilation volume for cooling is required, and the more dust is sucked from the outside environment there is a need to clean and maintain the dustproof net frequently, the operating cost will be increased even if a dustproof net is used.

2. To meet the requirement for equipment operating temperature under a low temperature environment, it is necessary to adopt a manner providing auxiliary heat by a heater, which consumes power energy and increases operating cost.

3. If AC is interrupted and the power supply depends on a backup storage battery, the auxiliary heating by the heater will increase the power consumption of the backup power source, which shortens the working hours of the backup power source. Therefore, when AC is interrupted under a low temperature environment, it is impossible to ensure an environment with appropriate temperature and relative humidity in the cabinet, especially in the region where the power net is unstable.

Summary of the Invention

Embodiments of the present invention provide a temperature and relative humidity control apparatus, processing apparatus, system and method for a cabinet, which can keep the temperature of the interior of the cabinet within an allowable range for normal operation of the electric facilities arranged in the cabinet, and which has a good dustproof and waterproof performance and can operate normally under a low temperature state.

The embodiment of the present invention is implemented by the following technical solution.

An embodiment of the present invention provides a cabinet temperature and relative humidity control apparatus for cooperating with a cooling vent path of the cabinet. The cabinet temperature and relative humidity control apparatus includes a reflow-mixing vent path and a circulation fan unit. A circulating air inlet of the reflow-mixing vent path is connected to an air outlet of the cooling vent path, and a circulating air outlet of the reflow-mixing vent path is connected to an air inlet of the cooling vent path. The circulation fan unit is arranged in the reflow-mixing vent path.

A partition structure is provided in the reflow-mixing vent path to divide the reflow-mixing vent path into an air inlet section and an air outlet section, the circulating air inlet is provided at the air inlet section, and the circulating air outlet is provided at the air outlet section. The partition structure is provided with a ventilation opening through which the air inlet section is communicated with the air outlet section, and the circulation fan unit is provided at the ventilation opening.

The reflow-mixing vent path is further provided with a reflowing air inlet and a reflowing air outlet, the reflowing air inlet is provided at the air outlet section of the reflow-mixing vent path, and the reflowing air outlet is provided at the air inlet section of the reflow-mixing vent path.

The apparatus further includes a direct-ventilation environment air inlet and a direct-ventilation environment air outlet, the direct-ventilation environment air inlet is connected to the air inlet of the cooling vent path, and the direct-ventilation environment air outlet is connected to the air outlet of the cooling vent path.

Airflow switching apparatus are provided at the ventilation opening, reflowing air inlet, reflowing air outlet, direct-ventilation environment air inlet and/or direct-ventilation environment air outlet and the closing or opening of the airflow switching apparatus is controlled by the airflow. Alternatively, a non-stopping circulation fan is provided at the ventilation opening, reflowing air inlet, reflowing air outlet, direct-ventilation environment air inlet and/or direct-ventilation environment air outlet.

The reflowing air inlet and reflowing air outlet, or the direct ventilation environment air inlet and direct ventilation environment air outlet are provided with an environment fan unit.

A dust filtering apparatus is arranged at the reflowing air inlet and/or the direct ventilation environment air inlet.

A heater is arranged in the cooling vent path and/or the reflow-mixing vent path.

Another embodiment of the present invention provides a cabinet temperature control processing apparatus. The apparatus includes: a temperature acquiring unit for acquiring real-time temperature values including an environment temperature value Ta, a temperature value Tin of air entering into a cooling vent path, and a temperature value Tout of air discharged from the cooling vent path; a target control value setting unit for setting target control values in advance and/or during control process, and the target control values including a Tout target control value SP_Tout and/or a Tin target control value SP_Tin and/or a target control value of temperature Thon required for turning on a heater and/or a target control value of temperature Thoff, required for turning off the heater and/or a target control value of lower critical temperature Tl and/or a target control value of upper critical temperature Th and/or a target control value ToutLimit of minimum expecting temperature at air outlet; a processing unit for controlling interior temperature and relative humidity of the cabinet according to the obtained temperature values including Ta, Tin, and Tout and the set target control values so as to keep the interior temperature and relative humidity of the cabinet within an allowable range for normal operation of equipments arranged in the cabinet.

The apparatus further including: a heater control unit for controlling on/off of a heater arranged in the cabinet; and/or a circulation fan control unit for controlling turning on and/or operating speed of a circulation fan arranged in the cabinet; and/or an environment fan control unit for controlling turning on and operating speed of an environment fan arranged in the cabinet.

The processing unit further includes: a normal temperature control unit for controlling control units inside the cabinet in a normal temperature control mode according to the temperature values obtained by the temperature acquiring unit, to control the interior temperature of the cabinet to SP_Tin and SP_Tout set by the target control value setting unit; and/or, a high temperature control unit for controlling the control units inside the cabinet in high temperature control mode according to the temperature values obtained by the temperature acquiring unit, to control the interior temperature of the cabinet to SP_Tin and SP_Tout set by the target control value setting unit; and/or, a low temperature control unit for controlling the control units inside the cabinet in low temperature control mode according to the temperature values obtained by the temperature acquiring unit, to control the interior temperature of the cabinet to SP_Tin and SP_Tout set by the target control value setting unit.

A further embodiment of the present invention provides a cabinet temperature control system, which includes a cooling vent path having an air inlet and an air outlet, and a cooling fan unit is provided in the cooling vent path. The system further includes a cabinet temperature and relative humidity control apparatus and/or a cabinet temperature control processing apparatus. The cabinet temperature and relative humidity control apparatus includes a reflow-mixing vent path and circulation fan unit. A circulating air inlet of the reflow-mixing vent path is connected to an air outlet of the cooling vent path, and a circulating air outlet of the reflow-mixing vent path is connected to an air inlet of the cooling vent path. The circulation fan unit is provided in the reflow-mixing vent path. The cabinet temperature control processing apparatus is used to control temperature and relative humidity of the system within an allowable range for normal operation of equipments arranged in the cabinet.

A still further embodiment of the present invention provides a method for controlling a cabinet temperature including: obtaining temperature values including an environment temperature value Ta, a temperature value Tin of air entering into a cooling vent path and a temperature value Tout of air discharged from the cooling vent path; and outputting a control signal according to the obtained temperature values including the environment temperature value Ta, the temperature value Tin of air entering into cooling vent path and the temperature value Tout of air discharged from the cooling vent path, and controlling the operation of relevant equipments arranged in the cabinet according to preset target control values, so as to keep interior temperature and relative humidity of the cabinet within an allowable range for normal operation of the equipments.

Controlling the operation of the equipments in the cabinet includes controlling a cooling fan unit, which includes: if Tout < SP_Tout which is a target control value of Tout, environment ventilation volume is decreased to increase Tout until Tout = SP_Tout; and if Tout > SP_Tout, environment ventilation volume is increased to decrease Tout until Tout = SP_Tout.

Controlling the operation of the control unit in the cabinet includes controlling a heater, which includes: if Tout $\leq$ Thon which is the temperature value required for turning on the heater, turn on the heater of the temperature control unit; if Tout > Thoff which is the temperature value required for turning off the heater, turn off the heater of the temperature control unit.

The controlling the operation of the control unit in the cabinet includes controlling a circulation fan unit, which includes: if Tin < SP_Tin which is the target control value of Tin, the proportion of the reflowing hot air is increased until Tin = SP_Tin; if Tin > SP_Tin, the proportion of the reflowing hot air is decreased until Tin = SP_Tin.

The method further includes:

if lower critical temperature Tl < Ta < upper critical temperature Th, it is determined that the equipment is under a normal temperature operating state, it is firstly defined that SP_Tout = Ta + $\Delta$Tin + $\Delta$Tout to meet the requirement for the cooling, then it is defined that SP_Tin=Ta + $\Delta$Tin to meet the requirement for controlling the relative humidity of the equipment, in which $\Delta$Tin is the temperature difference to be maintained between the environment air temperature and the temperature of air entering into the cooling vent path and $\Delta$Tout is the temperature difference to be maintained between the temperature of air discharged from the cooling vent path and the temperature of air entering into the cooling vent path, to meet the requirement for cooling; or

if Ta $\geq$ Th, it is determined that the equipment is under a high temperature operating state, it is defined that SP_Tout = Ta + $\Delta$Th, in which $\Delta$Th is the temperature difference to be maintained between the temperature of air discharged from cooling vent path and the temperature of air entering into the cooling vent path when the equipment operates under high temperature environment; or,

if Ta < Tl, it is determined that the equipment is under low temperature operating state, and it is defined that SP_Tout = ToutLimit; or,

when there is no environment ventilation volume, the circulation ventilation volume is defined between 80% and 100% of maximum circulation ventilation volume; else,

$$SP\_Tin = Tl + \vartriangle Tin.$$

When T1 < Ta < Th, before defining SP_Tout = Ta + ΔTin ΔTout, the method further includes:

$$if\ Ta + \vartriangle Tin + \vartriangle Tout > Th + \vartriangle Th,\ SP\_Tout = Th + \vartriangle Th;$$

else,

$$SP\_Tout = Ta + \vartriangle Tin + \vartriangle Tout;$$

or,

$$if\ Ta + \vartriangle Tin > Th,\ SP\_Tin = Th;$$

else,
when it is in temperature return region, SP_Tin = Ta + ΔTin.
When T1 < Ta < Th and Ta < Th +ΔT of the temperature return region, the control units in the cabinet operate in a normal temperature operating mode.
When Ta ≥ Th and it is necessary to set the upper limit T_over of high temperature for the equipment, the method further includes:

   if Ta +ΔTh > T_over, SP_Tout = T_over; else,
   if there is no high temperature limit requirement for the equipment, SP_Tout = Ta+ Δ Tin.

The method for determining the Th value and the Tin value includes:

   selecting the larger one of the following Th as the Th:

      the Th obtained by inquiring a extremum map of temperature and relative humidity or obtained according to an extremum relationship between local temperature and relative humidity of the equipment, and
      the Th determined by an extremum diagram of temperature difference control reference value and ΔTin; and
      obtaining the ΔTin according to the humidity extremum at high temperature.

The Th value is determined by inquiring from the extremum map of temperature and relative humidity according to the target relative humidity of the equipment; or
the Th is determined according to the extremum relationship between the local temperature and humidity of the location where the equipment is located.
The Th is adjusted according to the equipment time hazard rate.
The method further includes estricting the minimum air outlet expecting temperature value ToutLimit to prolong the equipment dustproof, service life, improve the heat preservation effect at low temperature, and reduce noise at normal temperature.
The method of restricting the minimum air outlet expecting temperature value further includes: defining SP_Tout = ToutLimit when the calculated target control value SP_Tout of the temperature value Tout of air discharged from the cooling vent path is less than ToutLimit.
The ToutLimit is in a range from 25°C to 50°C.
The method further includes: determining the target temperature and humidity value according to the local temperature and humidity condition, and controlling the temperature rise of the equipment by controlling the ratio of hot air entering into the equipment to environment air entering into the equipment so as to reduce the relative humidity of air entering into the equipment.

It can be seen from the above mentioned technical solutions provided by the embodiments of the present invention that the embodiments of the present invention have following advantageous effects:

1. A characteristic of good cooling at a high temperature, and a characteristic of heating-up and heat preservation under a low temperature environment;

2. The heat consumption of the equipment itself is used to heat the outside environment air so as to reduce the relative humidity, and controls the relative humidity by adjusting the ventilation volume of cold and hot air, which does not affect on the cooling performance of the equipment and achieve a relatively high performance-price ratio;

3. Because the temperature at the air outlet is controlled, the ventilation volume for cooling of the equipment is strictly restricted; while a part of the ventilation volume circulates in the cabinet and thus the air entering the cabinet from the outdoors is reduced, which reduces the dust entered the cabinet from outside.

Brief Description of the Drawings

Figure 1 is a schematic diagram illustrating the related direct-ventilation cooling solution;

Figure 2 is a configuration diagram of a system according to the related technical solution;

Figure 3 is a flowchart according to the related control solution;

Figure 4 is a configuration diagram illustrating a cabinet provided with a temperature control system according to an embodiment of the present invention in the case that air circulates in the cabinet ;

Figure 5 is a schematic diagram illustrating the cabinet shown in Figure 4 when cold and hot air mixed with each other;

Figure 6 is a schematic diagram illustrating direct ventilation situation of the cabinet shown in Figure 4;

Figure 7 is a schematic block diagram of a processing unit of the cabinet temperature control system according to the present invention;

Figure 8 is a diagram illustrating the relationship between the limit values of temperature and relative humidity ;

Figure 9 is a schematic diagram illustrating a temperature control curve according to one preferred embodiment of the present invention;

Figure 10 is a flowchart of an embodiment of the present invention;

Figure 11 is a procedure chart illustrating a control of environment ventilation volume by an environment fan unit according to an embodiment of the present invention;

Figure 12 is a procedure chart illustrating a control of circulating ventilation volume by a circulation fan unit according to an embodiment of the present invention;

Figure 13 is a flowchart illustrating the operation of a heater arranged in the cabinet according to an embodiment of the present invention;

Figure 14 is a flowchart illustrating a control of a processing mode of a normal temperature module according to an embodiment of the present invention;

Figure 15 is a flowchart illustrating a control of a processing mode of a high temperature module according to an embodiment of the present invention;

Figure 16 is a flowchart illustrating a control of a processing mode of a low temperature module according to an embodiment of the present invention;

Figure 17 is a flowchart illustrating a temperature control process of the cabinet temperature control system according to the present invention without considering the application under a low temperature environment;

Figure 18 is a configuration diagram of a cabinet temperature and relative humidity control apparatus according to an embodiment of the present invention; and

Figure 19 is a reference diagram illustrating the operation state of the cabinet temperature and relative humidity control apparatus shown in Figure 18.

Detailed Description of the Embodiments

The present invention will be further described as follows in detail in conjunction with the accompany drawings and embodiments.

An embodiment of the present invention provides a cabinet temperature control system, which includes a cooling vent path having an air inlet and an air outlet, the cooling vent path is provided with a fan unit, and the system further includes a cabinet temperature and relative humidity control apparatus and a cabinet temperature control processing apparatus.

A circulating air inlet of a reflow-mixing vent path defined in the cabinet temperature and relative humidity control apparatus is connected to the air outlet of the cooling vent path, and a circulating air outlet of the reflow-mixing vent path is connected to the air inlet of the cooling vent path.

The cabinet temperature control processing apparatus is configured to control the temperature and relative humidity of the system within an allowable range for normal operation of equipment; the cabinet temperature control processing apparatus can be arranged inside the cabinet or independently arranged outside the cabinet.

The cabinet temperature and relative humidity control apparatus according to the embodiment of the present invention is configured to cooperate with the cooling vent path, including:

a reflow-mixing vent path and a circulation fan unit;

a circulating air inlet of the reflow-mixing vent path being connected to an air outlet of the cooling vent path, and a circulating air outlet of the reflow-mixing vent path being connected to an air inlet of the cooling vent path;

the circulation fan unit is provided in the reflow-mixing vent path.

Figures 4-6 are schematic views illustrating a cabinet temperature control system according to an embodiment of the present invention. The cabinet temperature control system is configured to maintain the temperature and relative humidity of air inside the cabinet within an allowable range for normal operation of the equipment. In general, the equipment inside the cabinet may be a user board subrack of an access network, a baseband board subrack of a base station, a transceiver module or a power source module, and the like.

As shown in Figure 4, a vertical partition plate 30 is provided in the cabinet, the top end and bottom end of the vertical partition plate 30 are respectively fixed on the top plate and bottom plate of the cabinet. The vertical partition plate 30 divides the cabinet interior into a cooling vent path 10 for the cooling of the heat-generating equipment inside the cabinet, and a reflow-mixing vent path 20 communicating an air outlet 14 of the cooling vent path 10 with an air inlet 15 of the cooling vent path 10. The air outlet 14 and air inlet 15 are respectively located at the upper side and lower side of the cooling vent path 10, for discharging air of the cooling vent path 10 or introducing air into the cooling vent path 10.

In the embodiment, the cooling vent path 10 is a cavity enclosed by a front door, a back door, a top plate, a bottom plate, the partition plate 30, and a side plate, for accommodating primary operating equipment therein. In the cooling vent path 10, a cooling fan unit 13 is provided for driving cooling air into the cooling vent path 10 from the air inlet 15, and discharging the air from the air outlet 14 after absorbing the heat in cooling vent path 10, which is generated by the heat-generating apparatus such as an upper subrack 11, a lower subrack 12 and the like, so that the temperature of the air in the cooling vent path 10 is preserved within the normal range. It can be appreciated, the cooling fan unit 13 may include one or more fans, the type of the fan may be an axial fan, a centrifugal fan, or other fans.

The reflow-mixing vent path 20 is a cavity enclosed by a front door, a back door, a top plate, a bottom plate, the partition plate 30 and a side plate, in which some apparatus with low power consumption as well as low requirements for temperature and relative humidity are installed. A circulating air inlet and a circulating air outlet, which are respectively communicated with the air outlet 14 and the air inlet 15 of the cooling vent path 10, are provided at the upper and lower sides of the reflow-mixing vent path 20, respectively, such that the air outlet 14 and the air inlet 15 of the cooling vent path 10 are communicated with each other, thereby the hot air flowing out from the air outlet 14 can flow back into the cooling vent path 10 through the air inlet 15. In Figure 4, the circulating air inlet and circulating air outlet of the reflow-mixing vent path 20 share with the air outlet 14 and air inlet 15 of the cooling vent path 10 respectively. Certainly, the reflow-mixing vent path 20 may also has independent circulating air inlet and circulating air outlet as required. In such condition, it only needs to use ventilation pipes to communicate the circulating air inlet and outlet with the air outlet 14 and air inlet 15, respectively.

A horizontal partition plate 32 is provided in the middle of the reflow-mixing vent path 20, for dividing the reflow-mixing vent path 20 into upper and lower sections, i.e. an air inlet section and an air outlet section. The circulating air inlet described above is provided in the air inlet section, in other words, the air inlet section is communicated with the air outlet 14 of the cooling vent path 10, so as to receive the hot air discharged from the air outlet 14. The circulating air outlet described above is provided in the air outlet section, in other words, the air outlet section is communicated with the air inlet 15 of the cooling vent path 10. A ventilation port 321 through which the air inlet section is communicated with the air outlet section is defined in the horizontal partition plate 32. A circulation fan unit 23 is provided near the ventilation port 321 to drive the air of the air inlet section into the air outlet section through the ventilation port 321, and back to the cooling vent path 10 through the air inlet 15.

A reflowing air inlet 26 and a reflowing air outlet 27 are provided in the reflow-mixing vent path 20. Each of the reflowing air inlet 26 and the reflowing air outlet 27 is communicated with the outside environment. The reflowing air inlet 26 is provided at the air outlet section of the reflow-mixing vent path 20 so that the air outlet section is communicated with the outside environment; and a first environment fan unit 22 is provided at the reflowing air inlet 26 of the reflow-mixing vent path 20 so as to draw the outside air to the air outlet section of the reflow-mixing vent path 20. The reflowing air outlet 27 is provided at the air inlet section of the reflow-mixing vent path 20 so that the air inlet section is communicated with the outside environment; and a second environment fan unit 21 is provided at the reflowing air outlet 27 of the reflow-mixing vent path 20 so as to discharge part or all of the hot air entering the air outlet section of the reflow-mixing vent path 20 to the outside environment. It can be appreciated that the first and second environment fan units 21 and 22 each includes one or more fans, and the fan type may be axial flow fan, centrifugal fan, or other kinds of fans.

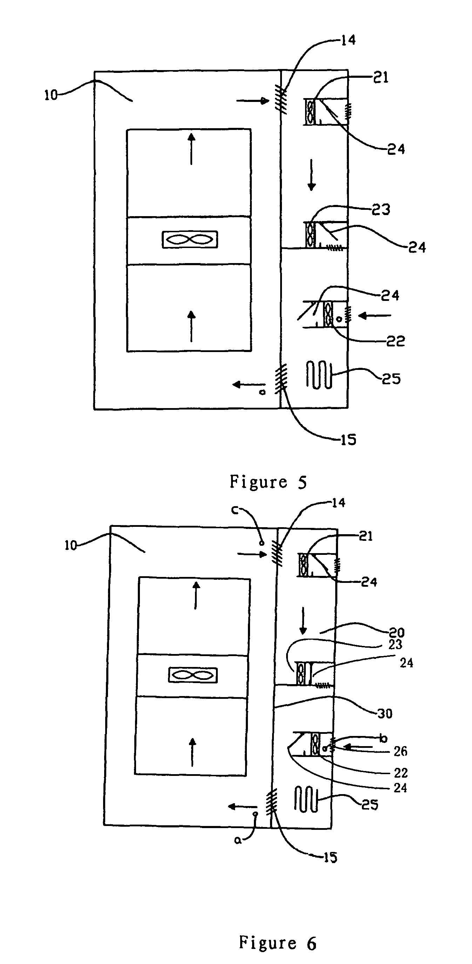

An airflow shutting-off or blocking apparatus is provided at each of the reflowing air inlet 26, reflowing air outlet 27 and ventilation port 321, paralleling with the corresponding fan unit. The airflow shutting-off or blocking apparatus is opened when the fan unit operates, and the airflow shutting-off or blocking apparatus is closed to prevent all or most of the airflow from passing through the ventilation port when the fan unit does not operate. The airflow shutting-off or blocking apparatus may be a simple shutter, an electric control valve, and the like. In a simplified configuration, a non-stopping circulation fan which operates at a low speed may be configured to maintain a downward air pressure. In this embodiment, as shown in Figure 5 and Figure 6, the airflow shutting-off or blocking apparatus is a shutter 24 which can open only in one direction. When the fan unit operates, the shutter 24 is driven to be opened by the pressure generated by the air blown out from the fan; and when the fan unit cease operate, the shutter 24 is closed under the action of gravity. In the simplified configuration, the non-stopping circulation fan is configured to maintain the downward air pressure.

Figure 5 is a schematic view illustrating the cabinet shown in Figure 4 when cold and hot air are mixed from each other. In such condition, the shutters 24 at the first environment fan unit 22, the second environment fan unit 21 and the circulation fan unit 23 each is opened, and the cold and hot air pass through them.

Figure 6 is a schematic view illustrating the cabinet shown in Figure 4 under the direct ventilation mode. In such condition, the shutters 24 at the first environment fan unit 22 and the second environment fan unit 21 are opened, and the shutter 24 at the circulation fan unit 23 is closed (in the simplified configuration, there is no the shutter). Therefore, the outside air directly passes through the shutter 24 of the first environment fan unit 22 into the cooling vent path 10 from the air inlet 15, therefore a cooling processing for the equipment inside the cabinet is carried out in the cooling vent path 10 in the arrow direction shown in the Figure 6. Then, air in the cooling vent path 10 passes through the outlet 14 into the outside environment from the shutter 24 of the second environment fan unit 21.

The cabinet temperature control system according to this embodiment may further include an environment air inlet for direct ventilation and an environment air outlet for direct ventilation, and the environment air inlet and environment air outlet for direct ventilation are provided in the cooling vent path 10, with the environment air inlet for direct ventilation communicated with the air inlet of the cooling vent path 10 and the environment air outlet for direct ventilation communicated with the air outlet of the cooling vent path 10. Also, an airflow switching apparatus, the closing and opening of which is controlled by airflow, may be provided at the environment air inlet and environment air outlet for direct ventilation. Further, the environment fan unit may be provided at the environment air inlet and environment air outlet for direct ventilation and a dust-filtering apparatus may be provided at the environment air inlet for direct ventilation.

In order to satisfy the requirements of low temperature environment or additional heat treatment in the cabinet temperature control system of this embodiment, it is possible that a heater 25 is arranged at the bottom of the reflow-mixing vent path 20 so as to carry out a function of auxiliary heating. Certainly, the heater 25 may also be placed in the cooling vent path 10, or both in the cooling vent path 10 and in the reflow-mixing vent path 20.

In the cabinet temperature control system of this embodiment, it is possible that a labyrinth structure (not shown) is arranged at the reflowing air inlet 26 and reflowing air outlet 27 for water-proofing, and a dust-filtering system such as dustproof net is arranged at the reflowing air inlet 26 or/and air inlet 15 for dust-proofing.

In addition, it should be noted that the fan unit involved in the cabinet temperature control system of this embodiment is not limited to using the ordinary fan, rather than may use other air driving apparatus.

As shown in Figure 6, in order to achieve an intelligent control, the cabinet temperature control system of this embodiment includes: a temperature sensor a at the air inlet 15 of the cooling vent path 10 so as to detect the temperature of the air entering the cooling vent path 10; a temperature sensor c at the air outlet 14 so as to detect the temperature of the hot air discharged from the cooling vent path 10; and a temperature sensor b at the reflowing air inlet 26 of the reflow-mixing vent path 20 so as to detect the environment temperature.

The cabinet temperature control processing apparatus according to this embodiment includes:

a temperature acquiring unit for acquiring real-time temperature values including an environment temperature value Ta, a temperature value Tin of air entering the cooling vent path, a temperature value Tout of air discharged from the cooling vent path, etc.;

a target control value setting unit for setting target control values in advance and/or during control process, including any one value or more values selected from the following group: a target control value SP_Tout of the temperature Tout, a target control value SP_Tin of the temperature Tin, a target control value of a temperature Thon required for turning on the heater, a target control value of temperature Thoff required for turning off heater, a target control value of lower critical temperature Tl, a target control value of upper critical temperature Th, and a target control value of minimum expecting temperature ToutLimit of the air outlet;

processing unit for controlling the operation of the circulation fan unit and/or environment fan unit and/or heater and/or cooling fan unit in the cabinet temperature and relative humidity control apparatus based on the acquired temperature values including Ta, Tin, and Tout and the set target control values, to keep the interior temperature and relative humidity of the cabinet within the allowable range for normal operation of equipment.

The cabinet temperature control processing apparatus further includes:

a heater control unit adapted for controlling turning-on/turning-off of the heater; and/or

a circulation fan control unit adapted for controlling turning-on of the circulation fan and/or operating speed of the circulation fan; and/or

an environment fan control unit adapted for controlling -turning-on of the environment fan and operating speed of the environment fan.

The processing unit includes:

a normal temperature control unit adapted for controlling the operation of the cooling fan control unit and/or heater control unit and/or circulation fan control unit and/or environment fan control unit in a normal temperature control mode according to the temperature values acquired by the temperature acquiring unit, to control the interior temperature of the cabinet to the target control values SP_Tin and SP_Tout set by the target control value setting unit; and/or

a high temperature control unit adapted for controlling the operation of the cooling fan control unit and/or heater control unit and/or circulation fan control unit and/or environment fan control unit in high temperature control mode according to the temperature values acquired by the temperature acquiring unit, to control the interior temperature of the cabinet to the target control value SP_Tout set by the target control value setting unit, since the equipment is under the high temperature stage, the environment humidity has been within the target range and thus it is unnecessary to control SP_Tin; and/or

a low temperature control unit adapted for controlling the operation of the cooling fan control unit and/or heater control unit and/or circulation fan control unit and/or environment fan control unit in a low temperature control mode according to the temperature values acquired by the temperature acquiring unit, so as to control the interior temperature of the cabinet to the target control valve SP_Tin and SP_Tout set by the target control value setting unit.

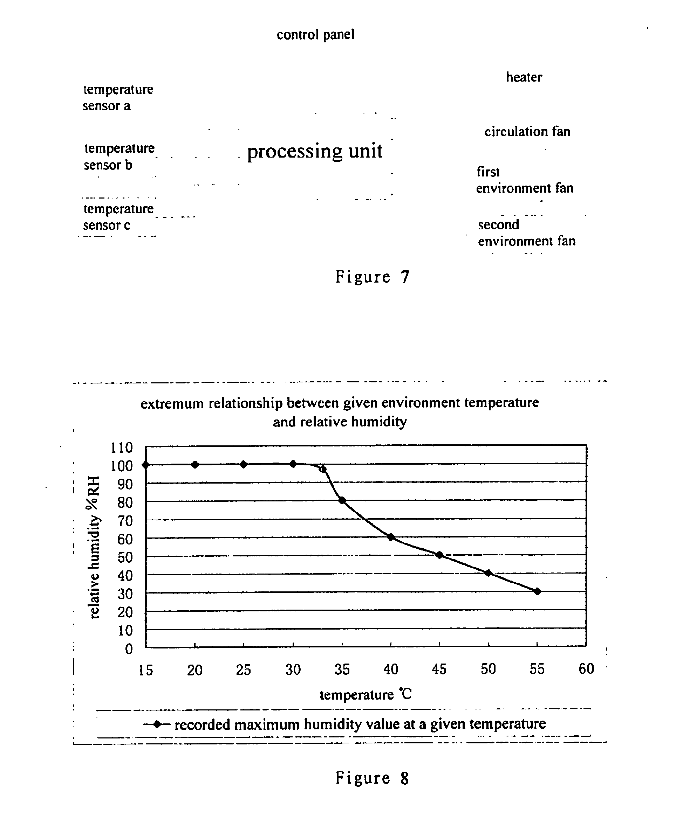

Figure 7 illustrates a schematic block diagram of the cabinet temperature control processing apparatus according to this embodiment. As shown in Figure 7, the processing unit of the cabinet temperature control processing apparatus is the essential portion of this control system and is provided with four input ports and four output ports. The four input ports are respectively connected to the temperature sensors a, b, c, and a control panel, while the four output ports are respectively connected to the circulation fan unit, the first environment fan unit, the second environment fan unit, and the heater. It can be appreciated that the processing unit may be placed either inside the cabinet temperature system or outside the cabinet temperature system as long as the connection of processing unit with other components can be achieved.

The control panel is configured to input cabinet control parameters into the processing unit according to user's requirements or cabinet applications. The cabinet control parameters to be set generally includes: a lower critical temperature parameter Tl of the outside environment, an upper critical temperature parameter Th of the outside environment, a temperature difference parameter $\Delta T$ (including a temperature difference $\Delta Tout$ to be maintained between the temperature of air discharged from the cooling vent path and the temperature of air entering the cooling vent path, and a temperature difference $\Delta Tin$ to be maintained between the environment air temperature and the temperature of air entering the cooling vent path, and further including a temperature difference $\Delta Th$ to be maintained between the temperature of air discharged from cooling vent path and the temperature of air entering the cooling vent path when the system is to be operated at a high outside temperature). Furthermore, when there is a need to restrict the temperature at the air outlet, it is also necessary to set the air outlet minimum expecting temperature value, and when there is a need to turn on or turn off the heater in the system, it is also necessary to set the temperature value Thon required for turning on the heater and temperature value Thoff required for turning off the heater.

During a specific control process, above-mentioned parameters are input into the processing unit by the control panel; then the temperature sensors a, b, c send the detected temperature values Tin, Ta (environment temperature), and Tout to the processing unit, respectively; next, the processing unit make a calculation and obtains the target control value SP_Tin of the temperature Tin of air entering the cooling vent path and the target control value SP_Tout of the temperature Tout of air discharged from the cooling vent path; after correcting the control parameters, the control signals are output to control the operation of circulation fan unit, the first environment fan unit, the second environment fan unit, the cooling fan unit and the heater, respectively, so that the temperature value of air inside the cabinet meets the requirements of the SP_Tin and SP_Tout, thereby achieving the object of controlling the temperature and relative humidity of air inside cabinet. It can be appreciated that these parameters may also be preset during manufacturing and be stored in the processing unit, thus the users need not to set the parameters by themselves. The parameters may be modified when the type of the outside environment in which the cabinet is located changes. If the outside environment in which the cabinet is located changes from A-level environment with relatively good air condition to C-level environment with relatively bad air condition, it is possible to properly increase $\Delta Tin$ so as to reduce the relative humidity of air entering the cabinet, thereby guaranteeing the cabinet to adapt to the environment.

Hereafter, by the example of communication and electronic equipment, the meaning of the parameters of the processing units in the cabinet temperature control system according to this embodiment is described as following.

The parameters are set with reference to the following relative humidity control principle:

When communication and electronic equipment are installed in an outdoor cabinet, in general, it is necessary to maintain the temperature of air inside the outdoor cabinet above -5°C-0°C, so as to ensure the reliable operation of the equipment arranged inside the cabinet. Moreover, copper is the primary signal transferring media for the communication and electronic equipments, thus the equipment corrosion is mainly caused by copper corrosion. Because 60%RH is the critical relative humidity point of copper corrosion, so the equipment corrosion can be effectively suppressed by controlling the relative humidity of the cabinet interior below 60%RH. In the C-level environment with relatively bad air environment, because harmful gases or salt materials in the environmental increase, it is necessary to properly reduce the relative humidity by 30%-40%.

When the relative humidity is controlled below 60%RH, the equipment corrosion can be suppressed and it can prevent from dewing in the cabinet. When the environment temperature is below 0°C, because the environment temperature is excessively low, the probability that the air relative humidity exceeds 60% is extremely low. Therefore, In this condition, it is unnecessary to consider the control of the relative humidity and it only need to control the air temperature to meet the requirements set by the user. When the environment temperature is greater than 0°C and less than 40°C, the probability that air relative humidity exceeds 60% is high. Therefore, the air may be properly heated to reduce the relative humidity of the air so as to ensure the relative humidity below 60%RH. When the environment temperature exceeds 40°C, the probability that air relative humidity exceeds 60% is extremely low, in such condition, it is unnecessary to control the air relative humidity and it only need to consider the ventilation and cooling of the equipment under the high temperature environment.

The specific setting of the parameters is as following.

Tl refers to the upper limit temperature value of low temperature for normal operation of the equipment, while Tl may also be the upper limit temperature value at which air humidity is less than the critical relative humidity point of equipment corrosion, i.e. when the environment temperature is less than Tl, air humidity is less than the critical relative humidity point of equipment corrosion. In this condition, it needs to perform the temperature control of the cabinet and does not need to perform the humidity control. The preferred range of T1 is -5-0°C, which is determined by the environment temperature and the performance of the equipment itself.

Th refers to the lower limit temperature value of high temperature for normal operation of the equipment, while Th may also be the lower limit temperature value when air humidity is less than the critical relative humidity point of equipment corrosion under the high temperature environment, i.e. when the environment temperature is higher than Th, air humidity is less than the critical relative humidity point of equipment corrosion, in such condition, it also only needs to perform the temperature control of the cabinet and does not need to perform the humidity control. The preferred range of Th is 38-45°C, which is determined by the local environment and the performance of the equipment itself.

Now, the specific manner to determine Th is described. In order to control the interior relative humidity of the equipment below a specific critical value (RHc), it is inquired from a high temperature and high humidity record of environment (see Figure 8, which is department of the defense standard of British) that the relative humidity extremum is below RHc after the environment becomes Th, in such condition, the relative humidity value meets the requirement for normal operation of the equipment. Therefore, it only need to consider ventilation and cooling problem of the equipment when the environment temperature becomes higher than Th, and doesn't need to control the temperature of the entered air. Further, Th and ΔTin may be determined based on the relationship between the temperature extremum and humidity extremum of the equipment in the local environment to more better design the control parameters adapted to the local environment.

Now, the specific method for determining the Th will be described. It can be seen from Figure 8, when the environment temperature is between 15°C-32°C, the relative humidity extremums of the record are all at 100%RH; when the environment temperature is greater than 32°C, the relative humidity extremums of the record exponentially decrease. The reason of decrease lies in that the vapor pressure of the natural environment can never exceed the saturated vapor pressure at the temperature of the vaporization source, which means the vapor pressure can not exceed the set upper limit. As to dew point and vapor concentration, there is the same situation. As known, the source of water is generally ocean. However, even at Persian Gulf which is the sea with highest temperature, the temperature of the sea surface rarely exceeds 32°C. Therefore, dew point value at 32°C can be regarded as the upper limit value of the dew point, i.e. the theoretical maximum value of vapor concentration. That is, 32°C can be regarded as an important reference value for temperature difference control.

Proper Th point is chosen as the Th value described in the present invention from the Th value inquired from Figure 8 and the Th value determined by an extremum diagram of temperature difference control reference value and ΔTin. The temperature difference control reference value generally can be chosen to 32°C, and the specific choosing principle is to compare the sum of 32 + ΔTin with the Th value obtained from the map of temperature and relative humidity extremums shown in Figure 8 and take the larger as the Th value described in the present invention. Furthermore, in practice, the value Th can be properly adjusted according to the actual time hazard rate of the electronic and communication equipment so as to determine the Th value more suitably, or may be determined by acquiring the extremum relationship of temperature and humidity under the local environment.

Ta refers to the air temperature of the outside environment. In this embodiment, Ta is obtained by calculating average value of several Ta values acquired within a period of time. With this method, the effect of uneven cold and hot airflow of the natural environment on monitoring of Ta by the equipment processing unit can be smoothed or reduced. In practice, such method for determining Ta, in which the dithering is eliminated, by use of average valve is significant.

For a convenient description, the temperature control processing modes are divided according to the analysis of the Ta value by the processing unit of the temperature and relative humidity control apparatus. In particular, when T1 < Ta < Th, the temperature state of the outside environment is a normal temperature state, and the processing mode carried by the processing unit of the temperature and relative humidity control apparatus is the normal temperature processing mode. Moreover, in order to ensure system stability and smooth transition during states transform, a constant temperature region and a temperature return region are properly added in the normal temperature processing mode. When Ta ≥ Th, the temperature state of the outside environment is a high temperature state, and the processing mode of the processing unit of the temperature and relative humidity control apparatus is a high temperature processing mode. When Ta ≤ Tl, the temperature state of the outside environment is a low temperature state, and the processing mode of the processing unit of the temperature and relative humidity control apparatus is a low temperature processing mode.

The temperature difference parameter ΔTout refers to the temperature difference to be maintained between the temperature of air discharged from the cooling vent path and the temperature of air entering the cooling vent path so as to well dissipate the heat generated by the interior heat-generating equipment of the cabinet and ensure the normal cooling of the equipment. ΔTout can be determined according to thermodynamics principle and the property of the equipment itself. In practice, the value ΔTout is a preset value within a range, but, in the following expressions of the specific implementing process, the value Δ Tout is a determinate value in the range. Other values in this range can also be regarded as the Δ Tout in the following expressions depending on the outside temperature and the performance of the equipment, i.e. any determinate value in the range of Δ Tout can be chosen as the Δ Tout which is used to achieve SP_Tout by the processing unit. The preferable range of the ΔTout is between 8-15°C.

The temperature difference parameter ΔTin refers to the temperature difference to be maintained between the temperature of air in outside environment and the temperature of air entering the cooling vent path so as to cause the relative humidity of air inside the cabinet below the critical relative humidity point of the equipment corrosion. ΔTin can be determined according to thermodynamics principle and the property of the equipment itself. In practice; ΔTin is a preset value within a range, but in the following expressions of the implementing process the ΔTin is a determinate value in the range. Depending on the outside environment temperature and the equipment property, other values in this range can also be regarded as the value of ΔTin in the following expressions, i.e. any determinate value in the range of ΔTin can be chosen as the ΔTin which is used to achieve SP_Tin by the processing unit. The preferable range of ΔTin is between 10-15°C or 20-25 °C.

The temperature difference parameter ΔTh refers to the temperature difference to be maintained between the temperature of air discharged from cooling vent path and the temperature of air entering the cooling vent path when the system is operated under the high temperature environment. The preferable range of ΔTh is between 8-15°C.

In practice, other parameters to which the specific embodiment of the invention relate include Td, Thon, Thoff, SP_Tout, SP_Tin:

Td is the critical value at which the system enters the constant temperature region, after the outside environment temperature rises to Td, as the outside environment temperature rises, it is necessary to keep the temperature of the air inlet of the cooling vent path and temperature of the air outlet of the cooling vent path unchanged; Td = Th - ΔTin;

Thon is the temperature value at which the heater should be turned on, and which is determined by the environment temperature and the property of the equipment itself, i.e. when the temperature of the equipment does not reach this temperature, the equipment would be unable to operate normally, thus it is needed to turn on the heater to rise the operating environment temperature of the interior equipment of the cabinet, so as to achieve the normal starting of the equipment under the low temperature.

Thoff is the temperature value at which the heater should be turned off, and which is determined by the environment temperature and the property of the equipment itself, i.e. when the temperature of the equipment reaches this temperature, the equipment would be able to operate normally, thus it is unnecessary to rise the operating environment temperature of the interior equipment of the cabinet by the heater.

SP_Tout is the target control value of Tout, this target control value is determined by the processing unit according to the outside environment temperature and equipment property, and the environment ventilation volume of the cabinet can be increased or decreased by adjusting the rotate speed of the environment fan of the system so as to make Tout reach to SP_Tout.

SP_Tin is the target control value of Tin, this target control value is determined by the processing unit according to the outside environment temperature and equipment property, and the circulation ventilation volume of the cabinet can be increased or decreased by adjusting the rotate speed of the circulation fan of the system so as to make Tin reach to SP_Tin.

Now, the specific manner for determining SP_Tout and SP_Tin will be described.

After the temperature sensor b detects the temperature value Ta, SP_Tout and SP_Tin is defined as follows:

$$\text{if } Ta < Tl, \quad SP\_Tin = Tl + {}^{\vartriangle}Tin; \; SP\_Tout = Tl + {}^{\vartriangle}Tin + {}^{\vartriangle}Tout;$$

$$\text{if } Tl < Ta < Td, \quad SP\_Tin = Ta + {}^{\vartriangle}Tin; \; SP\_Tout = Ta + {}^{\vartriangle}Tin + {}^{\vartriangle}Tout;$$

$$\text{if } Td < Ta < Th, \quad SP\_Tin = Th; \; SP\_Tout = Th + {}^{\vartriangle}Th;$$

$$\text{if } Ta \geq Th, \quad SP\_Tout = Ta + {}^{\vartriangle}Th;$$

in such condition, it is not to be control Tin.

In order to prolong the dustproofing life of the equipment and maintain a low noise at normal temperature, it is possible to define the minimum expecting temperature value of the air outlet. For example, if the SP_Tout obtained by calculating is less than ToutLimit, ToutLimit is considered as SP_Tout to ensure SP_Tout >= ToutLimit. In this way, the service life of the dust filtering unit of the embodiment according to the invention can be prolonged, the heat-preservation effect at low temperature can be enhanced, and it is possible to reduce the noise at normal temperature. The preferred range of ToutLimit is 25-50°C.

It should be noted that, in various interior equipment, for example, in which the media for transferring signal is other materials rather than copper, it is necessary to adjust the specific range of the above-mentioned parameters according to the property of the material so as to match with the signal transfer media.

In this embodiment, in order to ensure that the interior equipment of the cabinet can smoothly transform under various temperature states regardless of the change of outside environment, it is provided with a temperature return region and a constant temperature region in the normal temperature state.

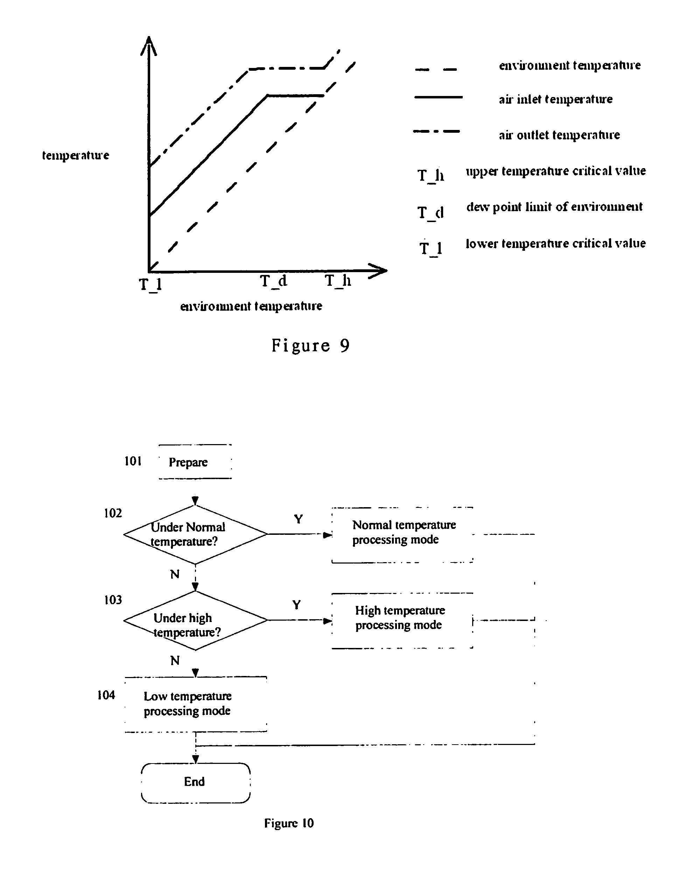

As shown in Figure 9, when the environment temperature T1 rises to Td, as the outside environment temperature rises, the temperature of the air inlet of the equipment cooling vent path rises. After the outside environment air in which the temperature gradually rises circulates through the interior of the equipment, the air temperature is higher than the temperature of the air inlet of the equipment cooling vent path, and rises along with the rising of the air inlet temperature. That is, it is necessary to maintain the temperature difference between the temperature of the air inlet of the cooling vent path and the environment temperature, and the temperature difference between the temperature of the air outlet of the cooling vent path and the temperature of the air inlet of the cooling vent path. When the environment temperature rises to Td, there is only a need to keep the temperature of the air inlet of the cooling vent path unchanged at an upper critical temperature, the object of controlling the relative humidity can be achieved, while the object of cooling the equipment can be achieved by keeping the temperature difference between temperature of the air outlet of the cooling vent path and the temperature of the air inlet to be ΔTh.in such condition, the processing mode of the processing unit of the cabinet temperature and relative humidity control apparatus is under the normal temperature processing mode. Further, when the outside environment temperature rises to Th, the system enters the high temperature state.

Now, the design principle of the temperature return region will be described.

In this embodiment, when the outside environment transits from the normal temperature state to the high temperature state, in order to avoid the impact on the temperature and relative humidity of the electrical equipment inside the cabinet when the outside temperature abruptly rises to Th value and thus to ensure that the interior temperature of the equipment can transit smoothly, a temperature return region is provided to add ΔT to the temperature value of the normal temperature state. When the cabinet is at the temperature return lower limit, the processing mode of the processing unit of the cabinet temperature and relative humidity control apparatus is the normal temperature processing mode, such that the normal temperature state can smoothly transit to the high temperature state. The $\Delta T$ of the temperature return region is determined by the conversion relationship between the ventilation volume and temperature of the system. The preferred range of $\Delta T$ is 2-3°C.

Now, the design principle of the constant temperature region is described as follow:

If $Td < Ta < Th$, the system enters the temperature return region state. and $SP\_Tin = Th$ and $SP\_Tout = Th + \Delta Th$. In such condition, the object of controlling the relative humidity can be achieved only by keeping the temperature of the air inlet of the cooling vent path unchanged at the upper critical temperature, while the object of the cooling for the equipment can be achieved by keeping the temperature difference between temperature of the air outlet of the cooling vent path and the temperature of the air inlet of the cooling vent path to be $\Delta Th$.

In this embodiment, before the outside environment transits from the normal temperate state to the high temperature state, i.e. when the outside environment temperature is between Td and Th, the value of SP_Tout is unchanged and SP_Tout=Th+$\Delta Th$. That is, when the outside environment temperature is between Td and Th, the normal temperature state enters the constant temperature state of Tout and thus it is necessary to keep $SP\_Tout = Th + \Delta Th$ so as to maintain the normal operation of the equipment inside the cabinet. Similarly, before the outside environment transits from the normal temperate state to the high temperature state, i.e. when the outside environment temperature is between Td and Th, the value of Tin is unchanged and $SP\_Tin = Th$. That is, when the outside environment temperature is between Td and Th, the equipment is under the constant temperature state of Tin, i.e. when the sum of Ta and $\Delta Tin$ exceeds the current Th, the normal temperature state enters the constant temperature state of Tin, and thus it is necessary to keep $SP\_Tin = Th$ so as to maintain the normal operation of the equipment inside the cabinet. For example, when transiting from the normal temperature state to the constant temperature region of Tin, it is assumed that $\Delta Tin$ is set as 7-10°C and Th is set as 40°C. in such condition, if the current environment temperature is 38°C, it is unnecessary to obtain SP_ Tin by calculating the sum of Ta and $\Delta Tin$, rather than only keeping $SP\_Tin = Th$; similarly, because Tin enters the constant temperature state, Tout also enters the constant temperature state.

The cabinet temperature control system in this embodiment can realize the following three operating states.

Under the first operating state, the circulation fan unit operates while the environment fan unit does not operate (shown as the arrow in Figure 4), air circulates in the cabinet interior through the cooling vent path 10 and the reflow-mixing vent path 20, without air exchange with the outside environment or with few air exchange through slots. This operating state is mainly applied to heat the cabinet interior in a self-circulating manner by the heat consumption of the equipment itself or an auxiliary heater 25 when the equipment is under the low temperature environment; it also may be applied to circularly heat the cabinet interior by the heat consumption of the equipment itself so as to reduce the relative humidity. This operating model is a main operating mode for the low power consumption equipment.

Under the second operating state, the circulation fan unit and the environment fan unit operate at the same time (shown as the arrow in Figure 5), a part of the hot air discharged from the cooling vent path is mixed with the cold air of the outside environment at a certain proportion and the mixed air subsequently returns to the cooling vent path 10 for ventilation and cooling of the equipment. In this operating state, the temperature and relative humidity of air entering the cooling vent path 10 can be adjusting by the heat generated by the equipment itself. The ventilation volume and the mixture ratio of the hot air in the cabinet interior to the cold air in the outside environment are determined by the processing unit of the cabinet temperature control system, such that all of the air entering the cooling vent path 10 can meet the requirements for temperature and relative humidity control. This operating state is mainly applied to control the equipment temperature and relative humidity when the equipment is under the normal temperature environment.

In the third operating state, the circulation fan unit does not operate The shutter effect can be simulated by the circulation fan operating at a low speed if the simplified configuration of the shutter of the circulation vent path is not provided and the environment fan unit operates (shown as the arrow in Figure 6), in this condition, the environment air directly flows into the cabinet to dissipate heat from the equipment. This operating state is mainly applied to achieve cooling for equipment when the equipment is under high temperature environment.

Hereinafter, a specific control method of one preferred embodiment of the invention will be described in detail with reference to Figs. 10-16.

Figure 10 is a flowchart of an overall control according to one preferred embodiment of the invention, the specific steps includes:

Step 101: Preparing stage. the processing unit detects the temperature value of the air inlet of the equipment (i.e. environment temperature) Ta, the temperature value of the air inlet of the cooling vent path of the equipment (i.e. temperature of air entering the cooling vent path) Tin and the temperature value of the air outlet of the cooling vent path of the equipment (i.e. temperature of air discharged from the cooling vent path) Tout by temperature sensor b, a, and c, respectively.

Step 102: Determine whether the equipment is under the normal temperature state according to Ta. If $T1 < Ta < Th$, it is determined that the outside environment temperature is under the normal temperature state, the processing unit adopts the normal temperature processing mode, and the procedure ends when completing this processing. If Ta is not within the range of $T1 < Ta < Th$, the procedure proceeds to step 103;

Step 103: Determine whether the equipment is under the high temperature state according to Ta. if Ta ≥ Th, it is determined that the outside environment temperature is under the high temperature state, the processing unit adopts the high temperature processing mode, and the procedure ends when completing this processing. If Ta value is not within the range of Ta ≥ Th, the procedure proceeds to step 104;

Step 104: The outside environment temperature is under the low temperature state, and the processing unit adopts the low temperature processing mode, and the procedure ends when completing this processing.

In above-mentioned steps, in order to ensure smooth transition between different temperature states, it is adopted such a determining manner that a certain temperature return region is added when determining the state points of the normal temperature, low temperature and high temperature. Of course, a certain temperature return difference is also kept in the control of the expecting temperature of entering air and discharged air.

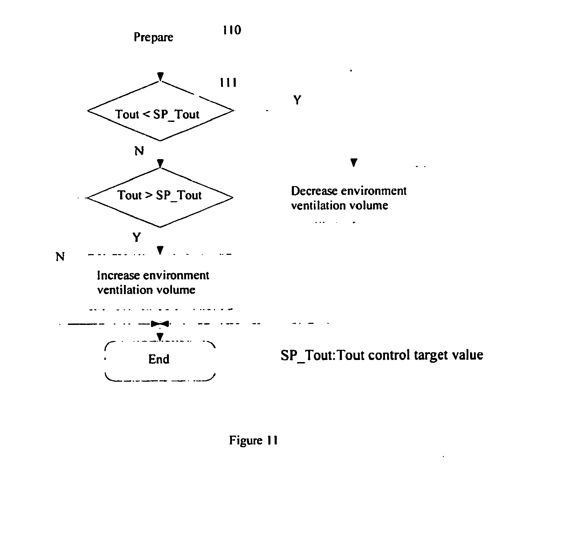

A control procedure chart illustrating the control of the environment ventilation volume by the environment fan unit is shown as Figure 11, the specific steps are as following:

Step 110: Monitor Tout;

Step 111: Compare Tout with SP_Tout. If Tout < SP_Tout, Tout increases with the decrease of the ventilation volume of the circulation environment fan unit until Tout=SP_Tout; if Tout > SP_Tout, Tout decreases with the increase of the ventilation volume until Tout = SP_Tout.

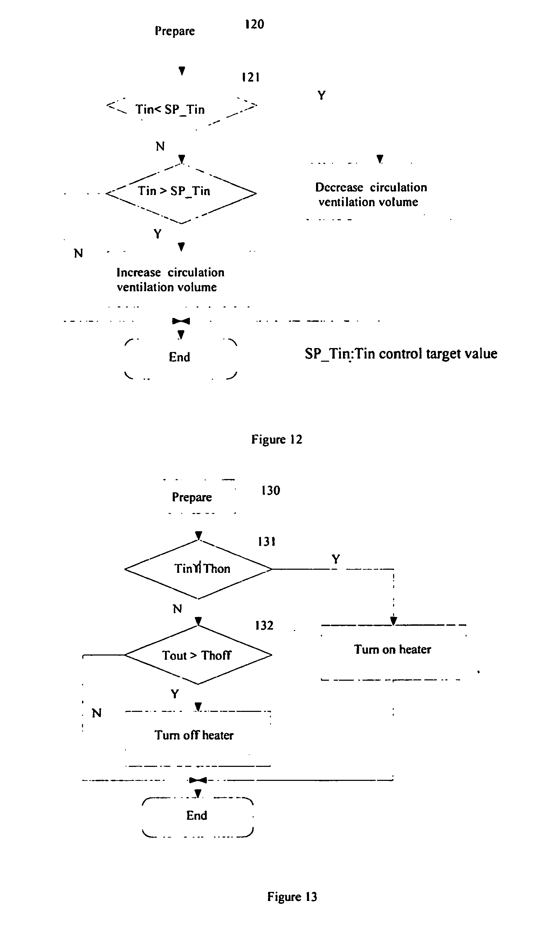

A control procedure chart illustrating the control of the circulation ventilation volume by the circulation fan unit is shown in Figure 12, the specific steps are as following:

Step 120: Monitor Tin;

Step 121: Compare Tin with SP_Tin. If Tin < SP_Tin, the proportion of the reflowing hot air is increased until Tin = SP_Tin; if Tin > SP_Tin, the proportion of the reflowing hot air is decreased until Tin = SP_Tm.

Whether the equipment operates under the low temperature state, the normal temperature state or the high temperature state, when the interior temperature of the cabinet is not at the rated temperature value Thon required for normal operation of the equipment, it is necessary to heat the air inside the cabinet.casein such condition, it is necessary to install a heater inside the cabinet. The operating flow of the heater inside the cabinet is shown as Figure 13, the specific steps are as following:

Step 130: Preparing stage, including: detecting the environment temperature Ta, the temperature Tin of air entering the cooling vent path, and the temperature Tout of air discharged from the cooling vent path;

Step 131: Compare Tout with Thon, if Tout ≤ Thon, the heater of the temperature control unit is turned on; if Tout > Thon, the procedure proceeds to step 132;

Step 132: Vompare Tout with Thoff, if Tout > Thoff, the heater of the temperature control unit is turned off; if Tout ≤ Thon, no any operation of turning on or turning off the heater is carried out.

Hereinafter, the processing modes of normal temperature, high temperature, and low temperature according to one preferred embodiment of the invention are respectively described in detail.

If T1 < Ta < Th, the processing unit adopts the normal temperature processing mode. The normal temperature processing mode includes a common processing mode of the normal temperature state and the constant temperature region processing mode;

If T1 < Ta < Td, the equipment is under the common processing mode of normal temperature state, and the operating state of the cabinet temperature control system is under the second operating state, in this condition, both the circulation fan unit and the environment fan unit operate, the processing unit respectively control the rotate speed of the circulation fan unit and the rotate speed of the environment fan unit according to the environment temperature value Ta, the temperature value Tin of air entering the cooling vent path and the temperature value Tout of air discharged from the cooling vent path, so as to adjust the mixture ratio of the reflowing hot air with respect to the environment air entering the cabinet. The specific adjusting method includes: setting the control target of the temperature value Tout of air discharged from the equipment cooling vent path as SP_Tout = Ta + Δin + ΔTout, so as to meet the requirement for the cooling of the equipment; then setting the control target of the temperature value Tin of air entering the equipment cooling vent path as SP_Tin = Ta + ΔTin, so as to meet the requirement for controlling the relative humidity of the equipment. Tin itself is a variable and Tout has relatively great influence on Tin. Accordingly, if Tout is used as the reference of Tin, a relatively great impact is applied on the stability of the system. Therefore, it is not to use Tout as the reference of Tin. On the contrary, the relatively stable Ta is use as the reference, which can quickly determine the ventilation of the equipment, and is advantageous to quickly find the balance between the environment and circulation ventilation volume.

When Td < Ta < Th, the equipment is under the constant temperature region processing mode, and it is necessary to keep Tout =Th + ΔTh and Tin = Th.

Considering the requirement for smooth transition of the air temperature in cabinet temperature control system, a temperature return region of ΔT°C is added during the transition from the normal temperature state to the high temperature state. The temperature return region is set in a manner such that the initial default temperature value of the temperature return region is the temperature value of the normal temperature state, i.e. when Ta ≥ Th + ΔT, the state of the equipment transits from the normal temperature state to the high temperature state, while when Ta < Th, the state of the equipment transits from the high temperature state to the normal temperature state.

The specific steps of the normal temperature processing mode of the cabinet temperature control system will be described in detail as follows.

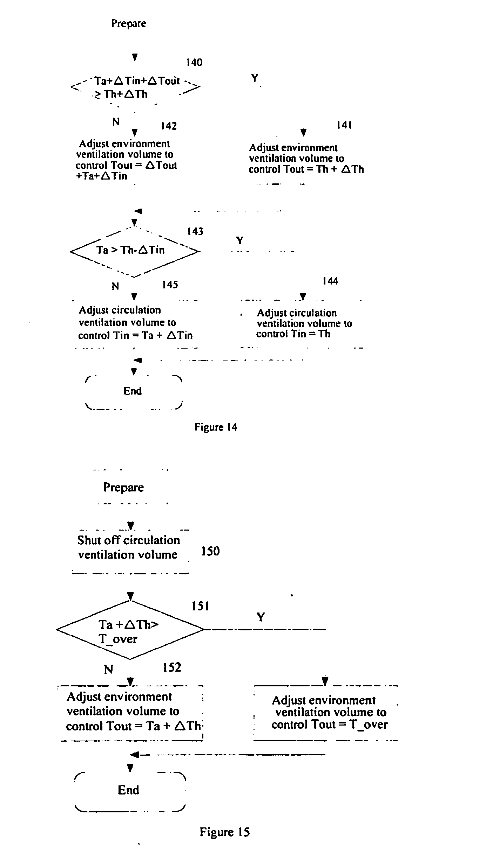

As shown in Figure 14, the procedure mainly includes the following steps:

Step 140: Determine whether the equipment is under the mode of entering Tout constant temperature state mode from the normal temperature state by adopting the constant temperature region processing mode. If $Ta + \Delta Tin + \Delta Tout > Th + \Delta Th$, the equipment is under Tout constant temperature state mode, and it is necessary to keep $Tout = Th + \Delta Th$, then the procedure proceeds to step 141. If the equipment is not under the mode of entering Tout constant temperature state mode from normal temperature state, the procedure proceeds to step 142;

Step 141: In this condition, the equipment is under the constant temperature region processing mode, the control target of Tout value is $SP\_Tout = Th + \Delta Th$, and the specific control process refers to step 111;

Step 142: In this condition, the equipment is under the common processing mode of normal temperature state, the control target of Tout value is $SP\_Tout = Ta + \Delta Tin + \Delta Tout$, the specific control process refers to step 111;

Step 143: Determine whether the equipment is under the mode of entering Tin constant temperature state mode from the normal temperature state by adopting the constant temperature region processing mode. If $Ta + \Delta Tin > Th$, the equipment is under the mode of entering Tin constant temperature state mode from the normal temperature state, and it is necessary to keep $Tin = Th$, then the procedure proceeds to step 144. If the equipment is not under the mode of entering Tin constant temperature state mode from the normal temperature state, the procedure proceeds to step 145;

Step 144: In this condition, the equipment is under the constant temperature region processing mode, the control target of Tin value is defined as $SP\_Tin = Th$, and the specific control process refers to step 121.

Step 145: In this condition, the equipment is under the common processing mode of normal temperature state, the control target of Tin value is defined as $SP\_Tin = Ta + \Delta Tin$, and the specific control process refers to step 121.

When $Ta \geq Th$, the processing unit adopts the high temperature processing mode. under the high temperature state, the operating state of the cabinet temperature control system is under the third operation state, in this condition. both the heater and circulation fan unit are turned off (in the simplified configure, the low speed circulation fan is configured to simulate the shutter effect), the environment fan unit operates. The processing unit adjusts the rotate speed of the environment fan unit according to the environment temperature Ta and temperature value Tout of air discharged from the cooling vent path, so as to adjust the volume of the environment air entering the cabinet such that a reasonable temperature difference $\Delta Th$ can be maintained between Tout and Ta, i.e. the control target of Tout value is defined as $SP\_Tout = Ta + \Delta Th$. As shown in Figure 15, the procedure mainly includes the following steps:

Step 150: The processing unit turns off the circulation fan unit to reduce the circulation ventilation volume to zero in the simplified configure, the low speed circulation fan is configured to simulate the effect of circulation shutter. The reason to do this is in that, under the high temperature state, the relative humidity of air inside equipment has been reached the control target, and the environment air can directly enter into the electric facilities to dissipate heat from the equipment;

Step 151: Set a high temperature upper limit T_over according to the requirement for high temperature control of the equipment, then comparing $Ta + \Delta Th$ and T_over. The method for setting T_over value includes: determining whether there is a need to set the high temperature upper limit for the interior equipment. If the determining result is affirmative, a high temperature limit T_over which is larger than Tout is set according to the property of the equipment, wherein T_over is a suitable high temperature limit area for the equipment and the desired T_over can be obtained according to the high temperature cooling of the board arranged inside the cabinet; if the determining result is negative, there is no need to set T_over.

When $Ta + \Delta Th > T\_over$, the control target of Tout value is $SP\_Tout = T\_over$, and the specific control process refers to step 111;

Step 152: If $Ta + \Delta Th < T\_over$ or there is no need to set T_over value, the control target of Tout value is defined as $SP\_Tout = Ta + \Delta Th$, and the specific control process refers to step 111.

When $Ta \leq T1$, the processing unit adopts the low temperature processing mode. Under the low temperature state, because the absolute temperature of the outside environment is relatively low, it is only necessary for the processing unit to control the interior temperature of the cabinet, without the need to control the interior relative humidity of the cabinet.

The SP_Tout value can be adjusted under each of the temperature states. The adjusting method includes: comparing the SP_Tout value with the preset ToutLimit. If $SP\_Tout < ToutLimit$, ToutLimit is used as the current SP_Tout value; if $SP\_Tout > ToutLimit$, it is to keep the current SP_Tout value, which certainly meets the requirement for the temperature limit of the air outlet and thus there is no need to correct SP_Touto

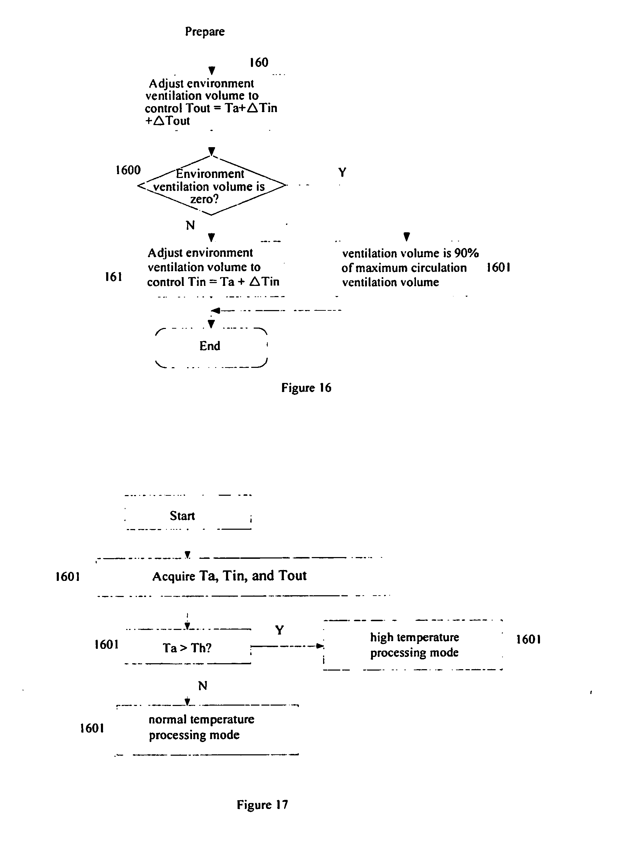

When there is no environment ventilation in the equipment, Tout value is very close to Tin value, and Tout Value is ToutLimit when there is set requirement for ToutLimit. When $Tout > T1 + \Delta Tin + \Delta Tout$, the amount of heat generated by the interior equipment themselves exceeds the amount of heat required for heating, thus it is necessary to actively dissipate the excessive heat to the outside environment. Therefore, in this condition, it is necessary to turn on the environment fan unit such that both the circulation fan unit and environment fan unit operate normally, while the processing unit respectively adjusts the rotate speed of the circulation fan unit and the rotate speed of the environment fan unit according to Ta, Tin, and Tout, so as to respectively control the ventilation volume of the hot air returning from the cooling vent path of the equipment and the ventilation volume of the environment cold air. By this way, the temperature of the air inlet of the equipment cooling vent path is maintained as Tin = Tl + $\Delta$Tin, and the temperature of the air outlet of the equipment cooling vent path is maintained as Tout = Tl + $\Delta$Tin + $\Delta$Tout or ToutLimit. As shown in Figure 16, the procedure mainly includes the following steps:

Step 160: When Tin $\leq$ Ta, determine firstly whether there is a need to turn on the environment fan unit to dissipate heat of the equipment under the low temperature state, and the control target of the Tout value is SP_Tout = Ta + $\Delta$Tin + $\Delta$Tout. The specific control process refers to step 111.

Step 1600: Determine whether there is environment ventilation volume, if there is no environment ventilation volume, the procedure proceeds to step 1601; if there is environment ventilation volume, i.e. the environment ventilation volume is not zero, the procedure proceeds to step 161;

Step 1601: In this comdition, there is no environment ventilation volume, i.e. the environment ventilation volume is zero, in this condition, the circulation ventilation volume is maintained at the high speed such that the circulation ventilation volume is between the 80% - 100% of the maximum circulation ventilation volume;

Step 161: In this comdition, there is environment ventilation volume, i.e. the environment ventilation volume is not zero, and the circulation ventilation volume is adjusted such that the control target of Tin value is SP_Tin = Ta + $\Delta$Tin. The specific control process refers to step 121.

The above are the detail operating steps of the equipment under three kinds of environment temperature. In practice, the processing unit of the equipment can be adjusted according to the specific requirement of the operation environment of the equipment. For example, when it is unnecessary to consider applying the equipment under the low temperature environment or it is unnecessary to consider to use the heater, it is possible to only consider designing a processing unit which satisfies the requirement for operating under normal temperature and/or high temperature environment, so as to save the manufacture cost of the equipment. Under the normal temperature and high temperature state, the specific steps carried out by the system are shown in Figure 17.

Step 171: Detect the environment temperature Ta, the temperature Tin of air entering the cooling vent path, and the temperature Tout of air discharged from the cooling vent path;

Step 172: Determine whether Ta is greater than Th; if the result is negative, the procedure proceeds to step 173; if the determining result is affirmative, the procedure proceeds to step 174;

Step 173: The processing unit adopts the normal temperature mode to carry out the processing;

Step 174: The processing unit adopts the high temperature mode to carry out the processing.

It is noted that, in addition to applying to the outdoor cabinet, the present invention can be applied to the indoor cabinet which is used more commonly. Many cabinets are installed in a simple machine room, and there is no proper control for temperature, dust, and relative humidity in such simple machine room, which brings the problems of temperature and environment corrosion in the equipment. The present invention can also solve the problem of temperature and humidity prevention in the equipment.

In addition, in view of a fault treatment, a backup design of fans (e.g., 1+1 type) may be provided at each of the air inlet and air outlet of the circulation vent path. That is, regardless of the operating state of the equipment, when a fan fault occurs, the backup fan raise an alarm to actively indicate that the fault fan should be replaced manually, and the circulation fan unit is turned off and the control mode is switched to the high temperature control mode. That is, what is firstly considered is to satisfy the requirement for the cooling of the equipment, other than the requirement for the relative humidity. Therefore, during this process, it is firstly considered not to satisfy the relative humidity requirement by the method of increasing the air inlet temperature; on the contrary, it is firstly consider satisfying the requirement of the cooling of the equipment by transitorily sacrificing the requirement for humidity control.

Because the impact of the relative humidity on the equipment corrosion is a long-time effect, and the control of the relative humidity is also a long-time effect, the problem of the relative humidity may be not firstly considered. The impact that the humidity does not meet the requirement of the equipment transitorily on the equipment is limited. Furthermore, when the fan unit fault is removed, the direct ventilation control system of the equipment recovers the normal temperature control and relative humidity control for the equipment.

The present invention adopts a unique vent path design and temperature and relative humidity control solution, and can reliably control the temperature and relative humidity of air inside equipment. Under low temperature environment, the heat consumption of the equipment itself is adequately used to carry out self-heating, and if necessary, auxiliary heating means is used to evenly heat the interior of the cabinet. Under high temperature environment, the outside environment air is directly used to carry out cooling, which eliminates the extra temperature difference and achieves the optimum cooling effect. Under the normal temperature environment, there is no need to use the additional heating means, and the interior relative humidity of the cabinet can be reduced by self-heating using the heat consumption of equipment itself, which can suppress corrosion, save energy and ensure reliable cooling. The invention can reduce the ventilation volume between the cabinet and environment, thus reduce dust entering the cabinet. In addition, compared with the temperature and relative humidity control apparatus such as air conditioner and heat exchanger, the present invention can reduce the cabinet volume, reduce noise and has an advantage on cost.

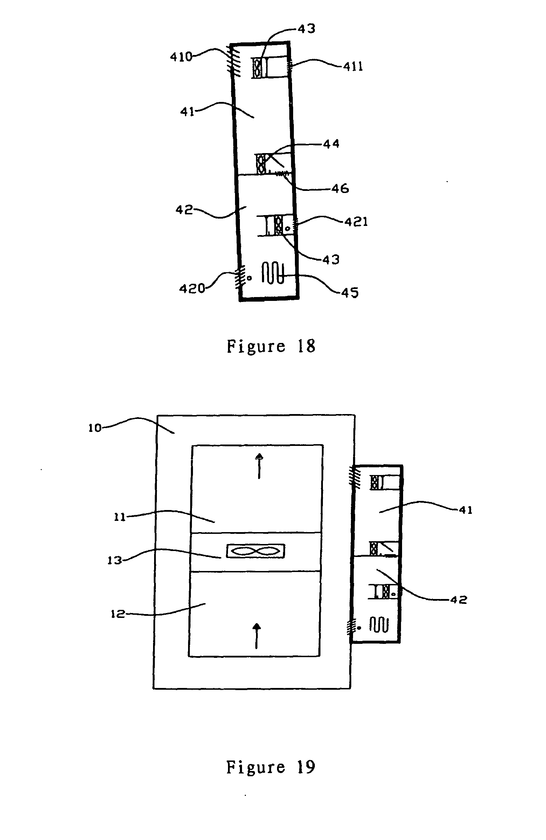

Figure 18 and Figure 19 illustrate a temperature and relative humidity control apparatus according to another embodiment of the invention; this temperature and relative humidity control apparatus is installed on the cabinet, and cooperates with the interior cooling vent path of the cabinet to achieve the temperature control. The structure of the temperature and relative humidity control apparatus is similar to the structure of the reflow-mixing vent path in the above embodiment. In particularly, it includes an air inlet section 41 and an air outlet section 42 spaced from each other. The air inlet section 41 is provided with a circulating air inlet 410 and a reflowing air outlet 411, and the air outlet section 42 is provided with a circulating air outlet 420 and a reflowing air inlet 421. Environment fan units 43 are provided near the reflowing air inlet 421 and the reflowing air outlet 411, the air inlet section 41 is communicated with the outside environment through the reflowing air outlet 411, and the air outlet section 42 is communicated with the outside environment through the reflowing air inlet 421. Ventilation hole 46 is provided between the air inlet section 41 and the air outlet section 42, and a circulation fan unit 44 is provided near the ventilation hole 46. The temperature and relative humidity control apparatus may further include a heater 45 and a control unit (not shown), and the like.

During the operating process, the circulating air inlet 410 is communicated with the air outlet of the cooling vent path 10 inside the cabinet, the circulating air outlet 420 is communicated with the air inlet of the cooling vent path 10 inside the cabinet, which can be directly connected or be indirectly connected through a conduit. The temperature control process is similar to that of the above embodiment, so it is not repeated herein. Because the separate temperature and relative humidity control apparatus can be installed on the cabinet as a standard temperature control module, similar to the heat exchanger and air conditioner, the application of this embodiment is more flexible and convenient.

Although the invention has been described through some exemplary embodiments, the invention is not limited to such embodiments. It is apparent that those skilled in the art can make various modifications and variations to the invention without departing from the principle and scope of the invention. The invention is intended to cover the modifications and variations provided that they fall in the scope of the protection scope defied by the appended claims or their equivalents

**Claims**

1. A cabinet temperature and relative humidity control apparatus for cooperating with a cooling vent path (10) of the cabinet having communication, electronic or power equipment arranged inside, the cooling vent path comprising an air inlet (15) and an air outlet (14) **characterized in that,** the cabinet temperature and relative humidity control apparatus comprises:

   a reflow-mixing vent path (20) being an enclosed cavity; and
   a circulation fan unit (23) arranged in the reflow-mixing vent path (20);
   wherein an airflow from the air outlet (14) of the cooling vent path (10)enters into the reflow-mixing vent path (20), and the airflow is driven by the circulation fan unit (23)to enter into the cooling vent path(10)through the air inlet (15); and
   a cabinet temperature and relative humidity control processing apparatus adapted to control the circulation fan unit (23) so as to control interior temperature and relative humidity in the cabinet within an allowable range.

2. The cabinet temperature and relative humidity control apparatus according to claim 1, **characterized in that,** the cabinet temperature control processing apparatus comprising:

   a temperature acquiring unit, adapted to acquire at least one temperature value ;
   a target control value setting unit, adapted to set at least one target control value;
   a processing unit, adapted to control the circulation fan unit (23)according to the at least one temperature value acquired by the temperature acquiring unit and the at least one target control value set by the target control value setting unit so as to keep the interior temperature within the allowable range.

3. The cabinet temperature and relative humidity control apparatus according to claim 2 , **characterized in that,** the cabinet temperature and relative humidity control apparatus further comprises a circulation fan control unit, wherein the processing unit is adapted to control the turning on and/or operating speed of the circulation fan unit (23) through controlling circulation fan control unit.

4. The cabinet temperature and relative humidity control apparatus according to claim 1, **characterized in that,** the cabinet temperature and relative humidity control apparatus further comprises a partition structure (32) arranged in the reflow-mixing vent path (20) to divide the reflow-mixing vent path (20) into an air inlet section and an air outlet section, the circulating air inlet (14) is provided at the air inlet section, and the circulating air outlet (15) is provided at the air outlet section; and the partition structure (32) is provided with a ventilation opening (321) through which the air inlet section is communicated with the air outlet section, and the circulation fan unit (23) is provided at the ventilation opening (321).

5. The cabinet temperature and relative humidity control apparatus according to claim 4, **characterized in that,** the reflow-mixing vent path (20) is further provided with a reflowing air inlet (26) and a reflowing air outlet (27), the reflowing air inlet (26) is provided at the air outlet section of the reflow-mixing vent path (20), and the reflowing air outlet (27) is provided at the air inlet section of the reflow-mixing vent path (20).

6. The cabinet temperature and relative humidity control apparatus according to claim 2, **characterized in that,** the cabinet temperature and relative humidity control apparatus further comprises a direct-ventilation environment air inlet and a direct-ventilation environment air outlet; and the direct-ventilation environment air inlet is connected to the air inlet (15) of the cooling vent path (10), and the direct-ventilation environment air outlet is connected to the air outlet (14) of the cooling vent path (10).

7. A cabinet temperature and relative humidity control apparatus according to claim 4, 5 or 6, **characterized in that,** airflow switching apparatus (24) are provided at any one or more of the ventilation opening (321), reflowing air inlet (26), reflowing air outlet (27), direct-ventilation environment air inlet and direct-ventilation environment air outlet, and the closing or opening of the airflow switching apparatus (24) is controlled by the airflow.

8. A cabinet temperature and relative humidity control apparatus according to claim 5 or 6, **characterized in that**, the reflowing air inlet (26) and reflowing air outlet (27), or the direct ventilation environment air inlet and direct ventilation environment air outlet are provided with an environment fan unit (21, 22), wherein the processing unit is further adapted to control the environment fan unit (21, 22) according to the at least one temperature value acquired by the temperature acquiring unit and the at least one target control value so as to keep the interior temperature within the allowable range.

9. A cabinet temperature and relative humidity control apparatus according to claim 8, **characterized in that**, the cabinet temperature and relative humidity control apparatus further comprises an environment fan control unit, wherein the processing unit is adapted to control the turning on and/or operating speed of the environment fan unit (21, 22) through the environment fan control unit.

10. A cabinet temperature and relative humidity control apparatus according to claim 5 or 6, **characterized in that**, a dust filtering apparatus is arranged at the reflowing air inlet (26) and/or the direct ventilation environment air inlet.

11. The cabinet temperature and relative humidity control apparatus according to one of claims 2 to 7, **characterized in that**, the cabinet temperature and relative humidity control apparatus further comprises a heater (25) arranged in the cooling vent path (10) and/or the reflow-mixing vent path (20), wherein the processing unit is further adapted to control the heater (25) according to the at least one temperature value acquired by the temperature acquiring unit and the at least one target control value so as to keep the interior temperature within the allowable range.

12. The cabinet temperature and relative humidity control apparatus according to claim 11, **characterized in that**, the cabinet temperature and relative humidity control apparatus further comprises a heater control unit, wherein the processing unit is adapted to control on/off of the heater (25) through controlling the heater control unit.

13. The cabinet temperature and relative humidity control apparatus according to claim 1, **characterized in that** the reflow-mixing vent path (20) comprises a circulating air inlet and a circulating air outlet, and the circulating air inlet is connected to the air outlet (14), the circulating air outlet is connected to the air outlet (15).

14. A cabinet temperature control system, comprising a cooling vent path (10) of a cabinet, and a cabinet temperature and relative humidity control apparatus according to any one of claims 1 to 12, wherein the cabinet temperature and relative humidity control apparatus cooperates with the cooling vent path (10) for control an interior temperature of the cabinet within an allowable range.

15. A method for controlling a cabinet temperature within a cabinet halving communication, or power equipment arranged, insides and cooled by a cooling vent path (10);
the method including the following steps:

connecting an air inlet (15) and an air outlet (14) of the cooling vent part (10) with a reflow mixing vent path (20) being an enclosed cavity, a circulation fan unit (23) being arranged in the reflow mixing vent path (20); obtaining at least one temperature value, and at least one target control value; outputting a control signal according to the at least one temperature value temperature value and the at least one preset target control value; controlling the circulation fan unit (23) according to the control signal, so as to keep interior temperature and relative humidity of the cabinet within an allowable range.

16. The method according to claim 15, **characterized in that,** the process of obtaining at least one temperature value within a cabinet comprises:

obtaining the at least one temperature value within a cabinet comprising one or more of an environment temperature value Ta, a temperature value Tin of air entering a cooling vent path (10) and a temperature value Tout of air discharged from the cooling vent path (10).

17. The method according to claim 15, **characterized in that,** the process of the controlling the operation of cooling or heating equipment arranged in the cabinet according to the control signal comprises:

controlling the turning on and/or operating speed of a circulation fan unit (23) and/or a environment fan unit(21 , 22) according to the control signal.

18. The method according to claim 15, **characterized in that,** the process of the controlling the operation of cooling or heating equipment arranged in the cabinet according to the control signal comprises:

controlling the on/off of a heater (25) according to the control signal.

**Patentansprüche**

1. Vorrichtung zur Steuerung von Schranktemperatur und relativer Luftfeuchtigkeit zum Zusammenwirken mit einem Kühllüftungsweg (10) des Schranks, in dem Kommunikations-, Elektronik- oder Energiegeräte angeordnet sind, wobei der Kühllüftungsweg einen Lufteinlass (15) und einen Luftauslass (14) umfasst, **dadurch gekennzeichnet, dass** die Vorrichtung zur Steuerung von Schranktemperatur und relativer Luftfeuchtigkeit Folgendes umfasst:

einen Rückstrommischungslüftungsweg (20), der ein umschlossener Hohlraum ist; und eine Umwälzgebläseeinheit (23), die in dem Rückstrommischungslüftungsweg (20) angeordnet ist; wobei ein Luftstrom von dem Luftauslass (14) des Kühllüftungswegs (10) in den Rückstrommischungslüftungsweg (20) eintritt und der Luftstrom durch die Umwälzgebläseeinheit (23) angetrieben wird, um durch den Lufteinlass (15) in den Kühllüftungsweg (10) einzutreten; und eine Verarbeitungsvorrichtung zur Steuerung von Schranktemperatur und relativer Luftfeuchtigkeit, die dazu ausgeführt ist, die Umwälzgebläseeinheit (23) zu steuern, um die Innentemperatur und die relative Luftfeuchtigkeit in dem Schrank innerhalb eines zulässigen Bereichs zu steuern.

2. Vorrichtung zur Steuerung von Schranktemperatur und relativer Luftfeuchtigkeit nach Anspruch 1, **dadurch gekennzeichnet, dass** die Verarbeitungsvorrichtung zur Steuerung von Schranktemperatur Folgendes umfasst:

eine Temperaturerfassungseinheit, die zur Erfassung mindestens eines Temperaturwerts ausgeführt ist; eine Einheit zur Einstellung des Sollsteuerwerts, die dazu ausgeführt ist, mindestens einen Sollsteuerwert einzustellen; eine Verarbeitungseinheit, die dazu ausgeführt ist, die Umwälzgebläseeinheit (23) gemäß dem mindestens einen von der Temperaturerfassungseinheit erfassten Temperaturwert und dem mindestens einen von der Einheit zur Einstellung des Sollsteuerwerts eingestellten Sollsteuerwert zu steuern, um die Innentemperatur innerhalb des zulässigen Bereichs zu halten.

3. Vorrichtung zur Steuerung von Schranktemperatur und relativer Luftfeuchtigkeit nach Anspruch 2, **dadurch gekennzeichnet, dass** die Vorrichtung zur Steuerung von Schranktemperatur und relativer Luftfeuchtigkeit weiterhin eine Umwälzgebläsesteuereinheit umfasst, wobei die Verarbeitungseinheit dazu ausgeführt ist, das Einschalten und/oder die Betriebsgeschwindigkeit der Umwälzgebläseeinheit (23) durch Steuerung der Umwälzgebläsesteuereinheit zu steuern.

4. Vorrichtung zur Steuerung von Schranktemperatur und relativer Luftfeuchtigkeit nach Anspruch 1, **dadurch gekennzeichnet, dass** die Vorrichtung zur Steuerung von Schranktemperatur und relativer Luftfeuchtigkeit weiterhin eine Abtrennstruktur (32) umfasst, die in dem Rückstrommischungslüftungsweg (20) angeordnet ist, um den Rückstrommischungslüftungsweg (20) in einen Lufteinlassabschnitt und einen Luftauslassabschnitt zu unterteilen, wobei der Umlufteinlass (14) an dem Lufteinlassabschnitt vorgesehen ist und der Umluftauslass (15) an dem Luftauslassabschnitt vorgesehen ist; und die Abtrennstruktur (32) mit einer Lüftungsöffnung (321) versehen ist, durch die der Lufteinlassabschnitt mit dem Luftauslassabschnitt verbunden wird, und die Umwälzgebläseeinheit (23) an der Lüftungsöffnung (321) vorgesehen ist.

5. Vorrichtung zur Steuerung von Schranktemperatur und relativer Luftfeuchtigkeit nach Anspruch 4, **dadurch gekennzeichnet, dass** der Rückstrommischungslüftungsweg (20) weiterhin mit einem Rückstromlufteinlass (26) und einem Rückstromluftauslass (27) versehen ist, wobei der Rückstromlufteinlass (26) an dem Luftauslassabschnitt des Rückstrommischungslüftungswegs (20) vorgesehen ist und der Rückstromluftauslass (27) am Lufteinlassabschnitt des Rückstrommischungslüftungswegs (20) vorgesehen ist.

6. Vorrichtung zur Steuerung von Schranktemperatur und relativer Luftfeuchtigkeit nach Anspruch 2, **dadurch gekennzeichnet, dass** die Vorrichtung zur Steuerung von Schranktemperatur und relativer Luftfeuchtigkeit weiterhin einen Direktlüftungsumgebungslufteinlass und einen Direktlüftungsumgebungsluftauslass umfasst; und der Direktlüftungsumgebungslufteinlass mit dem Lufteinlass (15) des Kühllüftungswegs (10) verbunden ist und der Direktlüftungsumgebungsluftauslass mit dem Luftauslass (14) des Kühllüftungswegs (10) verbunden ist.

7. Vorrichtung zur Steuerung von Schranktemperatur und relativer Luftfeuchtigkeit nach Anspruch 4, 5 oder 6, **dadurch gekennzeichnet, dass** Luftstromschaltvorrichtungen (24) an einer/einem beliebigen oder an mehreren der Lüftungsöffnung (321), des Rückstromlufteinlasses (26), des Rückstromluftauslasses (27), des Direktlüftungsumgebungslufteinlasses und des Direktlüftungsumgebungsluftauslasses vorgesehen sind und dass das Schließen oder Öffnen der Luftstromschaltvorrichtungen (24) durch den Luftstrom gesteuert wird.

8. Vorrichtung zur Steuerung von Schranktemperatur und relativer Luftfeuchtigkeit nach Anspruch 5 oder 6, **dadurch gekennzeichnet, dass** der Rückstromlufteinlass (26) und der Rückstromluftauslass (27) oder der Direktlüftungsumgebungslufteinlass und Direktlüftungsumgebungsluftauslass mit einer Umgebungslüftereinheit (21, 22) versehen sind, wobei die Verarbeitungseinheit weiterhin dazu ausgeführt ist, die Umgebungslüftereinheit (21, 22) gemäß dem mindestens einen von der Temperaturerfassungseinheit erfassten Temperaturwert und dem mindestens einen Sollsteuerwert zu steuern, um die Innentemperatur innerhalb des zulässigen Bereichs zu halten.

9. Vorrichtung zur Steuerung von Schranktemperatur und relativer Luftfeuchtigkeit nach Anspruch 8, **dadurch gekennzeichnet, dass** die Vorrichtung zur Steuerung von Schranktemperatur und relativer Luftfeuchtigkeit weiterhin eine Umgebungslüftersteuereinheit umfasst, wobei die Verarbeitungseinheit dazu ausgeführt ist, das Einschalten und/oder die Betriebsgeschwindigkeit der Umgebungslüftereinheit (21, 22) durch die Umgebungslüftersteuereinheit zu steuern.

10. Vorrichtung zur Steuerung von Schranktemperatur und relativer Luftfeuchtigkeit nach Anspruch 5 oder 6, **dadurch gekennzeichnet, dass** eine Staubfiltervorrichtung an dem Rückstromlufteinlass (26) und/oder an dem Direktlüftungsumgebungslufteinlass vorgesehen ist.

11. Vorrichtung zur Steuerung von Schranktemperatur und relativer Luftfeuchtigkeit nach einem der Ansprüche 2 bis 7, **dadurch gekennzeichnet, dass** die Vorrichtung zur Steuerung von Schranktemperatur und relativer Luftfeuchtigkeit weiterhin eine Heizvorrichtung (25) umfasst, die in dem Kühllüftungsweg (10) und/oder dem Rückstrommischungslüftungsweg (20) vorgesehen ist, wobei die Verarbeitungseinheit weiterhin dazu ausgeführt ist, die Heizvorrichtung (25) gemäß dem mindestens einen von der Temperaturerfassungseinheit erfassten Temperaturwert und dem mindestens einen Sollsteuerwert zu steuern, um die Innentemperatur innerhalb des zulässigen Bereichs zu halten.

**12.** Vorrichtung zur Steuerung von Schranktemperatur und relativer Luftfeuchtigkeit nach Anspruch 11, **dadurch gekennzeichnet, dass** die Vorrichtung zur Steuerung von Schranktemperatur und relativer Luftfeuchtigkeit weiterhin eine Heizvorrichtungssteuereinheit umfasst, wobei die Verarbeitungseinheit dazu ausgeführt ist, das Ein- und Ausschalten der Heizvorrichtung (25) durch Steuern der Heizvorrichtungssteuereinheit zu steuern.

**13.** Vorrichtung zur Steuerung von Schranktemperatur und relativer Luftfeuchtigkeit nach Anspruch 1, **dadurch gekennzeichnet, dass** der Rückstrommischungslüftungsweg (20) einen Umlufteinlass und einen Umluftauslass umfasst und der Umlufteinlass mit dem Luftauslass (14) verbunden ist und der Umluftauslass mit dem Luftauslass (15) verbunden ist.

**14.** System zur Steuerung von Schranktemperatur, das einen Kühllüftungsweg (10) eines Schranks und eine Vorrichtung zur Steuerung von Schranktemperatur und relativer Luftfeuchtigkeit nach einem der Ansprüche 1 bis 12 umfasst, wobei die Vorrichtung zur Steuerung von Schranktemperatur und relativer Luftfeuchtigkeit mit dem Kühllüftungsweg (10) zur Steuerung einer Innentemperatur des Schranks innerhalb eines zulässigen Bereichs zusammenwirkt.

**15.** Verfahren zur Steuerung einer Schranktemperatur in einem Schrank, in dem Kommunikations-, Elektronik- oder Energiegeräte angeordnet sind und der durch einen Kühllüftungsweg (10) gekühlt wird; wobei das Verfahren die folgenden Schritte umfasst:

Verbinden eines Lufteinlasses (15) und eines Luftauslasses (14) des Kühllüftungswegs (10) mit einem Rückstrommischungslüftungsweg (20), bei dem es sich um einen umschlossenen Hohlraum handelt, wobei eine Umwälzgebläseeinheit (23) in dem Rückstrommischungslüftungsweg (20) angeordnet ist; Erhalt mindestens eines Temperaturwerts und mindestens eines Sollsteuerwerts; Ausgabe eines Steuersignals gemäß dem mindestens einen Temperaturwert und dem mindestens einen voreingestellten Sollsteuerwert; Steuern der Umwälzgebläseeinheit (23) gemäß dem Steuersignal, um die Innentemperatur und die relative Luftfeuchtigkeit des Schranks innerhalb eines zulässigen Bereichs zu halten.

**16.** Verfahren nach Anspruch 15, **dadurch gekennzeichnet, dass** der Vorgang des Erhalts mindestens eines Temperaturwerts in einem Schrank :

Erhalt des mindestens einen Temperaturwerts in einem Schrank umfasst, der einen oder mehrere eines Umgebungstemperaturwerts Ta, eines Temperaturwerts Tin der in einen Kühllüftungsweg (10) eintretenden Luft und eines Temperaturwerts Tout der von dem Kühllüftungsweg (10) abgegeben Luft umfasst.

**17.** Verfahren nach Anspruch 15, **dadurch gekennzeichnet, dass** der Vorgang des Steuerns des Betriebs der in dem Schrank angeordneten Kühl- oder Heizeinrichtungen gemäß dem Steuersignal:

Steuern des Einschaltens und/oder der Betriebsgeschwindigkeit einer Umwälzgebläseeinheit (23) und/oder einer Umgebungslüftereinheit (21, 22) gemäß dem Steuersignal

umfasst.

**18.** Verfahren nach Anspruch 15, **dadurch gekennzeichnet, dass** der Vorgang des Steuerns des Betriebs der in dem Schrank angeordneten Kühl- oder Heizeinrichtungen gemäß dem Steuersignal:

Steuern des Ein-/Ausschaltens einer Heizvorrichtung (25) gemäß dem Steuersignal umfasst.


**Revendications**

**1.** Appareil de régulation de température et d'humidité relative d'armoire destiné à coopérer avec un chemin de ventilation de refroidissement (10) de l'armoire ayant un matériel de communication, un matériel électronique ou un matériel d'alimentation disposé à l'intérieur, le chemin de ventilation de refroidissement comprenant une entrée d'air (15) et une sortie d'air (14), **caractérisé en ce que** l'appareil de régulation de température et d'humidité relative d'armoire comprend :

un chemin de ventilation à mélange de reflux (20) étant une cavité fermée ; et

un dispositif ventilateur de circulation (23) disposé dans le chemin de ventilation à mélange de reflux (20) ;
dans lequel un flux d'air venant de la sortie d'air (14) du chemin de ventilation de refroidissement (10) pénètre dans le chemin de ventilation à mélange de reflux (20), et le flux d'air est entraîné par l'appareil ventilateur de circulation (23) pour pénétrer dans le chemin de ventilation de refroidissement (10) par l'entrée d'air (15) ; et
un appareil de traitement de régulation de température et d'humidité relative d'armoire adapté de façon à commander l'appareil ventilateur de circulation (23) de façon à réguler la température intérieure et l'humidité relative dans l'armoire dans les limites d'une plage admissible.

2. Appareil de régulation de température et d'humidité relative d'armoire selon la revendication 1, **caractérisé en ce que** l'appareil de traitement de régulation de température d'armoire comprend :

un dispositif d'acquisition de température, adapté de façon à acquérir au moins une valeur de température ;
un dispositif de définition de valeur de régulation cible, adapté de façon à définir au moins une valeur de régulation cible ;
un dispositif de traitement, adapté de façon à commander l'appareil ventilateur de circulation (23) d'après l'au moins une valeur de température acquise par le dispositif d'acquisition de température et d'après l'au moins une valeur de régulation cible définie par le dispositif de définition de valeur de régulation cible de façon à maintenir la température intérieure dans les limites de la plage admissible.

3. Appareil de régulation de température et d'humidité relative d'armoire selon la revendication 2, **caractérisé en ce que** l'appareil de régulation de température et d'humidité relative d'armoire comprend en outre un dispositif de commande du ventilateur de circulation, dans lequel l'unité de traitement est adapté de façon à commander la mise en marche et/ou la vitesse de fonctionnement du dispositif ventilateur de circulation (23) en commandant le dispositif de commande du ventilateur de circulation.

4. Appareil de régulation de température et d'humidité relative d'armoire selon la revendication 1, **caractérisé en ce que** l'appareil de régulation de température et d'humidité relative d'armoire comprend en outre une structure cloison (32) disposée dans le chemin de ventilation à mélange de reflux (20) afin de diviser le chemin de ventilation à mélange de reflux (20) en une section d'entrée d'air et une section de sortie d'air, l'entrée d'air de circulation (14) est prévue au niveau de la section d'entrée d'air, et la sortie d'air de circulation (15) est prévue au niveau de la section de sortie d'air ; et la structure cloison (32) est pourvue d'une ouverture de ventilation (321) par laquelle la section d'entrée d'air communique avec la section de sortie d'air, et l'appareil ventilateur de circulation (23) est prévu au niveau de l'ouverture de ventilation (321).

5. Appareil de régulation de température et d'humidité relative d'armoire selon la revendication 4, **caractérisé en ce que** le chemin de ventilation à mélange de reflux (20) est pourvu en outre d'une entrée d'air de reflux (26) et d'une sortie d'air de reflux (27), l'entrée d'air de reflux (26) est prévue au niveau de la section de sortie d'air du chemin de ventilation à mélange de reflux (20), et la sortie d'air de reflux (27) est prévue au niveau de la section d'entrée d'air du chemin de ventilation à mélange de reflux (20).

6. Appareil de régulation de température et d'humidité relative d'armoire selon la revendication 2, **caractérisé en ce que** l'appareil de régulation de température et d'humidité relative d'armoire comprend en outre une entrée d'air ambiant de ventilation directe et une sortie d'air ambiant de ventilation directe ; et l'entrée d'air ambiant de ventilation directe est reliée à l'entrée d'air (15) du chemin de ventilation de refroidissement (10), et la sortie d'air ambiant de ventilation directe est reliée à la sortie d'air (14) du chemin de ventilation de refroidissement (10).

7. Appareil de régulation de température et d'humidité relative d'armoire selon la revendication 4, 5 ou 6, **caractérisé en ce que** des appareils de commutation de flux d'air (24) sont prévus au niveau de n'importe laquelle ou lesquelles des ouvertures suivantes : ouverture de ventilation (321), entrée d'air de reflux (26), sortie d'air de reflux (27), entrée d'air ambiant de ventilation directe, et sortie d'air ambiant de ventilation directe, et la fermeture ou l'ouverture des appareils de commutation de flux d'air (24) est commandée par le flux d'air.

8. Appareil de régulation de température et d'humidité relative d'armoire selon la revendication 5 ou 6, **caractérisé en ce que** l'entrée d'air de reflux (26) et la sortie d'air de reflux (27), ou l'entrée d'air ambiant de ventilation directe et la sortie d'air ambiant de ventilation directe sont pourvues d'un dispositif ventilateur d'air ambiant (21, 22), dans lequel l'unité de traitement est adapté en outre de façon à commander l'appareil ventilateur d'air ambiant (21, 22) d'après l'au moins une valeur de température acquise par le dispositif d'acquisition de température et l'au moins une valeur de régulation cible de façon à maintenir la température intérieure dans les limites de la plage admissible.

**9.** Appareil de régulation de température et d'humidité relative d'armoire selon la revendication 8, **caractérisé en ce que** l'appareil de régulation de température et d'humidité relative d'armoire comprend en outre un dispositif de commande du ventilateur d'air ambiant, dans lequel l'unité de traitement est adapté de façon à commander la mise en marche et/ou la vitesse de fonctionnement du dispositif ventilateur d'air ambiant (21, 22) au moyen du dispositif de commande du ventilateur d'air ambiant.

**10.** Appareil de régulation de température et d'humidité relative d'armoire selon la revendication 5 ou 6, **caractérisé en ce qu'**un appareil de filtration de poussière est disposé au niveau de l'entrée d'air de reflux (26) et/ou de l'entrée d'air ambiant de ventilation directe.

**11.** Appareil de régulation de température et d'humidité relative d'armoire selon l'une des revendications 2 à 7, **caractérisé en ce que** l'appareil de régulation de température et d'humidité relative d'armoire comprend en outre un réchauffeur (25) disposé dans le chemin de ventilation de refroidissement (10) et/ou dans le chemin de ventilation à mélange de reflux (20), dans lequel l'unité de traitement est adapté en outre de façon à commander le réchauffeur (25) d'après l'au moins une valeur de température acquise par le dispositif d'acquisition de température et d'après l'au moins une valeur de régulation cible afin de maintenir la température intérieure dans les limites de la plage admissible.

**12.** Appareil de régulation de température et d'humidité relative d'armoire selon la revendication 11, **caractérisé en ce que** l'appareil de régulation de température et d'humidité relative d'armoire comprend en outre un dispositif de commande du réchauffeur, dans lequel l'unité de traitement est adapté de façon à commander la mise en marche/l'arrêt du réchauffeur (25) en commandant le dispositif de commande du réchauffeur.

**13.** Appareil de régulation de température et d'humidité relative d'armoire selon la revendication 1, **caractérisé en ce que** le chemin de ventilation à mélange de reflux (20) comprend une entrée d'air de circulation et une sortie d'air de circulation, et l'entrée d'air de circulation est reliée à la sortie d'air (14) et la sortie d'air de circulation est reliée à la sortie d'air (15).

**14.** Système de régulation de température d'armoire, comprenant un chemin de ventilation de refroidissement (10) d'une armoire, et un appareil de régulation de température et d'humidité relative d'armoire selon l'une quelconque des revendications 1 à 12, dans lequel l'appareil de régulation de température et d'humidité relative d'armoire coopère avec le chemin de ventilation de refroidissement (10) afin de réguler une température intérieure de l'armoire dans les limites d'une plage admissible.

**15.** Procédé pour réguler une température d'armoire à l'intérieur d'une armoire ayant un matériel de communication, un matériel électronique ou un matériel d'alimentation disposé à l'intérieur, et refroidie par un chemin de ventilation de refroidissement (10) ;
le procédé comprenant les étapes suivantes :

la liaison d'une entrée d'air (15) et d'une sortie d'air (14) du chemin de ventilation de refroidissement (10) avec un chemin de ventilation à mélange de reflux (20) qui consiste en une cavité fermée, un dispositif ventilateur de circulation (23) étant disposé dans le chemin de ventilation à mélange de reflux (20) ;
l'obtention d'au moins une valeur de température, et d'au moins une valeur de régulation cible ;
la production d'un signal de commande d'après l'au moins une valeur de température et l'au moins une valeur de régulation cible prédéfinie ;
la commande du dispositif ventilateur de circulation (23) d'après le signal de commande, de façon à maintenir la température intérieure et l'humidité relative de l'armoire dans les limites d'une plage admissible.

**16.** Procédé selon la revendication 15, **caractérisé en ce que** le processus d'obtention d'au moins une valeur de température à l'intérieur d'une armoire comprend :

l'obtention de l'au moins une valeur de température à l'intérieur d'une armoire comprenant une ou plusieurs des valeurs suivantes : une valeur de température ambiante Ta, une valeur de température Tin de l'air pénétrant dans un chemin de ventilation de refroidissement (10) et une valeur de température Tout de l'air déchargé du chemin de ventilation de refroidissement (10).

**17.** Procédé selon la revendication 15, **caractérisé en ce que** le processus de commande du fonctionnement du matériel de refroidissement ou de chauffage disposé dans l'armoire d'après le signal de commande comprend :

la commande de la mise en marche et/ou de la vitesse de fonctionnement d'un dispositif ventilateur de circulation (23) et/ou d'un dispositif ventilateur d'air ambiant (21, 22) d'après le signal de commande.

18. Procédé selon la revendication 15, **caractérisé en ce que** le processus de commande du fonctionnement du matériel de refroidissement ou de chauffage disposé dans l'armoire d'après le signal de commande comprend :

la commande de la mise en marche/l'arrêt d'un réchauffeur (25) d'après le signal de commande.

**Figure 1**

**Figure 2**

► Detect Tint, Uint

21

Uint > SPu?                          Y          ► Increase SPt

22

N

Decrease SPt, until SPt0        23

◄

24

Y          Tint = SPt?          N, and Tint < SPt        Decrease ventilation
▲                                                         volume

N, and Tint < SPt                                          25

Increase ventilation        26
volume

Figure 3

Figure 4

Figure 5

Figure 6

control panel

temperature
sensor a

temperature
sensor b

temperature
sensor c

processing unit

heater

circulation fan

first
environment fan

second
environment fan

Figure 7

extremum relationship between given environment temperature
and relative humidity

—◆— recorded maximum humidity value at a given temperature

Figure 8

temperature

— —  environment temperature

———  air inlet temperature

— · —  air outlet temperature

T_h  upper temperature critical value

T_d  dew point limit of environment

T_l  lower temperature critical value

environment temperature

T_l          T_d    T_h

Figure 9

101  Prepare

102  Under Normal temperature?  Y  →  Normal temperature processing mode

N

103  Under high temperature?  Y  →  High temperature processing mode

N

104  Low temperature processing mode

End

Figure 10

Prepare    110

Tout < SP_Tout    111

Y

N

Tout > SP_Tout

Decrease environment
ventilation volume

Y

N

Increase environment
ventilation volume

End

SP_Tout:Tout control target value

Figure 11

Figure 12

Figure 13

Prepare

▼    140

Ta+△Tin+△Tout ≥ Th+△Th     Y

N    142

Adjust environment ventilation volume to control Tout = △Tout +Ta+△Tin

141

Adjust environment ventilation volume to control Tout = Th + △Th

143

Ta > Th-△Tin    Y

N    145

Adjust circulation ventilation volume to control Tin = Ta + △Tin

144

Adjust circulation ventilation volume to control Tin = Th

End

Figure 14

Prepare

Shut off circulation ventilation volume    150

151

Ta +△Th> T_over    Y

N    152

Adjust environment ventilation volume to control Tout = Ta + △Th

Adjust environment ventilation volume to control Tout = T_over

End

Figure 15

34

Prepare

▼                160

Adjust environment
ventilation volume to
control Tout = Ta+$\triangle$Tin
+$\triangle$Tout

▼

1600    Environment               Y
        ventilation volume is
        zero?

N

▼                                 ▼

Adjust environment            ventilation volume is 90%
ventilation volume to         of maximum circulation    1601
161   control Tin = Ta + $\triangle$Tin      ventilation volume

◄

▼

End

Figure 16

Start

▼

1601         Acquire Ta, Tin, and Tout

▼              Y
1601    Ta > Th?    ────►    high temperature    1601
                              processing mode

N

▼

1601    normal temperature
        processing mode

Figure 17

35

Figure 18

Figure 19

**REFERENCES CITED IN THE DESCRIPTION**

**Patent documents cited in the description**

- EP 1311147 A

- US 5934368 A